# EUROPEAN PATENT APPLICATION

(11) **EP 4 604 270 A1**
(43) Date of publication of application: **20.08.2025**
(21) Application number: 24755976.8
(22) Date of filing: 30.01.2024
(51) Int. Cl.: H01M 10/613, H01M 50/244

(54) **ENERGY STORAGE SYSTEM**

(30) Priority: 15.02.2023 CN 202310140795; 27.04.2023 CN 202310481372
(71) Applicant: Huawei Digital Power Technologies Co., Ltd., Shenzhen, Guangdong 518043 (CN)
(72) Inventor: ZHOU, Kui, Shenzhen, Guangdong 518043 (CN); ZHANG, Chuang, Shenzhen, Guangdong 518043 (CN); CHEN, Mingshu, Shenzhen, Guangdong 518043 (CN)
(74) Representative: Isarpatent
(86) International application number: PCT/CN2024/074745
(87) International publication number: WO 2024/169602

(57) **Abstract**

This application provides an energy storage system. The energy storage system may include a cabinet and a liquid cooling unit. The cabinet may include a cabinet door and a cabinet body that are disposed in a hinged connection manner, and the cabinet door may be opened or closed relative to the cabinet body. The cabinet body may include a battery compartment and a power compartment. A battery module is disposed in the battery compartment, and a power module is disposed in the power compartment. The liquid cooling unit is disposed on a side that is of the cabinet door and that faces the cabinet body. The liquid cooling unit is connected to the battery module through a first liquid outlet pipe and a first liquid return pipe, and the liquid cooling unit is connected to the power module through a second liquid outlet pipe and a second liquid return pipe. In the energy storage system provided in this application, the battery module, the power module, and the liquid cooling unit are all disposed in the cabinet, so that integration of the energy storage system can be effectively improved, and mounting and maintenance efficiency of the energy storage system can be improved.

## Description

### CROSS-REFERENCE TO RELATED APPLICATIONS

This application claims priorities to Chinese Patent Application No. 202310140795.5, filed with the China National Intellectual Property Administration on February 15, 2023, and entitled "ENERGY STORAGE SYSTEM", and to Chinese Patent Application No. 202310481372.X, filed with the China National Intellectual Property Administration on April 27, 2023, and entitled "DOOR-MOUNTED LIQUID COOLING UNIT AND ENERGY STORAGE CABINET WITH DOOR-MOUNTED LIQUID COOLING UNIT", both of which are incorporated herein by reference in their entireties.

### TECHNICAL FIELD

This application relates to the field of energy storage technologies, and in particular, to an energy storage system.

### BACKGROUND

Electrochemical energy storage is widely used in industrial and commercial parks, office buildings, or power stations. In consideration of arrangement flexibility, a battery module, a battery management system (BMS), a power conversion system (PCS), a power distribution system, a fire extinguishing system, and the like can be usually integrated into a cabinet. In this way, when an energy storage system is delivered to a site requiring power-consuming equipment, the energy storage system can be connected to a grid for running with only a few cables.

However, in a current energy storage system, a cabinet of the energy storage system is usually designed with separate compartments. For example, a battery compartment, a power compartment, a temperature control compartment, and the like are separated. As a result, a structure of the cabinet is complex, and mounting and maintenance are inconvenient.

### SUMMARY

This application provides an energy storage system, to implement an integrated design of the energy storage system, to improve mounting and maintenance efficiency of the energy storage system.

According to a first aspect, this application provides an energy storage system. The energy storage system includes a cabinet and a liquid cooling unit, the cabinet includes a cabinet door and a cabinet body, and the cabinet door is in a hinged connection to the cabinet body, that is, the cabinet door may rotate relative to the cabinet body to implement opening or closing. The cabinet body may include a battery compartment and a power compartment, a battery module is disposed in the battery compartment, and the battery module may include a first liquid inlet and a first liquid outlet. The liquid cooling unit is disposed on a side that is of the cabinet door and that faces the cabinet body, and the liquid cooling unit may include a first liquid outlet pipe and a first liquid return pipe. The first liquid outlet pipe communicates with the first liquid inlet, and the first liquid return pipe communicates with the first liquid outlet. In the energy storage system provided in this application, the battery module is disposed in the battery compartment, and the liquid cooling unit is disposed on the cabinet door, so that an integrated design of the energy storage system can be effectively improved, thereby helping reduce a floor area of the energy storage system.

In an implementation, the cabinet body further includes the power compartment, a power module is disposed in the power compartment, and the power module includes a second liquid inlet and a second liquid outlet; and the liquid cooling unit further includes a second liquid outlet pipe and a second liquid return pipe, the second liquid outlet pipe communicates with the second liquid inlet, and the second liquid return pipe communicates with the second liquid outlet.

When the liquid cooling unit cools the battery module and the power module, a first cooling circulation loop may be formed between the liquid cooling unit and the battery module, and a second cooling circulation loop may be formed between the liquid cooling unit and the power module, so that an independent cooling circulation loop is formed between the liquid cooling unit and each of the battery module and the power module, and the two cooling circulation loops do not interfere with each other, thereby effectively improving heat dissipation efficiency of the battery module and the power module.

To cool the liquid cooling unit, the cabinet door may be further provided with a cooling area. The cooling area has a through hole, and the through hole may pass through the cabinet door in a direction from the outside of the cabinet body to the inside of the cabinet body. In this way, a projection of the liquid cooling unit on the cabinet door may overlap at least a part of the cooling area, so that the liquid cooling unit can be cooled by air that enters inside the cabinet through the through hole of the cooling area, and air heated by the liquid cooling unit can also be discharged to the outside of the cabinet through the through hole of the cooling area.

In this application, the liquid cooling unit may further include a unit housing, and a sealing ring may be further disposed between the unit housing and the cabinet door. The sealing ring may be disposed around the cooling area, and the unit housing may press the sealing ring towards the cabinet door, so that the sealing ring fills a gap between the unit housing and the cabinet door, to implement sealing between the unit housing and the cabinet door.

In addition, a flange edge may be further disposed on the unit housing, the flange edge may be attached to the cabinet door, and the flange edge may be fastened to the cabinet door. In this application, a manner of connecting the flange edge to the cabinet door is not limited in a radial direction. For example, the flange edge and the cabinet door may be fastened and connected by using a fastener such as a bolt.

In this application, a quantity of battery modules in the battery compartment is not limited. For example, there may be at least two battery modules. To cool the at least two battery modules, first liquid outlet branches may be disposed on the first liquid outlet pipe, and a quantity of first liquid outlet branches may be the same as a quantity of battery modules. In addition, first liquid return branches may be disposed on the first liquid return pipe, and a quantity of first liquid return branches may be the same as the quantity of battery modules. In this way, each first liquid outlet branch may communicate with the first liquid inlet of the battery module that is correspondingly disposed, and each first liquid return branch may communicate with the first liquid outlet of the battery module that is correspondingly disposed. Therefore, the first cooling circulation loop may be formed between the liquid cooling unit and each battery module, to effectively cool each battery module.

Similarly, a quantity of power modules in the power compartment may also be set based on a specific requirement. For example, there may be at least two power modules. To cool the power modules, second liquid outlet branches may be disposed on the second liquid outlet pipe, and a quantity of second liquid outlet branches may be the same as a quantity of power modules. In addition, second liquid return branches may be disposed on the second liquid return pipe, and a quantity of second liquid return branches may also be the same as the quantity of power modules. In this way, each second liquid outlet branch may communicate with the second liquid inlet of the power module that is correspondingly disposed, and each second liquid return branch may communicate with the second liquid outlet of the power module that is correspondingly disposed, so that the second cooling circulation loop may be formed between the liquid cooling unit and each power module, to effectively cool each power module.

In addition, in this application, a first stop valve may be disposed on the first liquid outlet pipe, and a second stop valve may be disposed on the second liquid return pipe, so that in a process of maintaining the liquid cooling unit and the battery module or replacing liquid, flow of a coolant between the liquid cooling unit and the battery module may be cut off by using the first stop valve and the second stop valve, to reduce a circuit fault caused by liquid leakage.

Similarly, a third stop valve may be disposed on the second liquid outlet pipe, and a fourth stop valve may be disposed on the second liquid return pipe, so that in a process of maintaining the liquid cooling unit and the power device or replacing liquid, flow of a coolant between the liquid cooling unit and the power device may be cut off by using the first stop valve and the second stop valve, to reduce a circuit fault caused by liquid leakage.

In a possible implementation of this application, the cabinet body may include a top wall and a bottom wall that are disposed opposite to each other. Usually, when the energy storage system is in normal use, the cabinet body may be placed on the ground in a direction from the top wall to the bottom wall. In addition, in a height direction of the cabinet body, the battery compartment and the power compartment may be disposed side by side, and the battery compartment is located on a side that is of the power compartment and that is close to the top wall. This may help reduce a floor area of the cabinet body.

In an implementation, at least two power modules are disposed in the power compartment, and the power modules may include cluster control boxes and power conversion systems. The cluster control box has a first output port and a first input port, the power conversion system has a second output port and a second input port, and the first output port is electrically connected to the second input port, so that the cluster control box can control the power conversion system. In addition, because the power conversion system may be disposed in the power compartment of the cabinet, there is no need to separately dispose an accommodating apparatus for the power conversion system outside the cabinet, so that a structure of the energy storage system can be simplified.

In addition, the first input port includes a first electrode interface and a second electrode interface, the at least two battery modules may be disposed in the battery compartment, and the at least two battery modules may be connected in series to form a first total electrode and a second total electrode. In this way, the first total electrode may be electrically connected to the first electrode interface, and the second total electrode may be electrically connected to the second electrode interface, so that the cluster control box may be used as a control switch of the battery module in the battery compartment, to implement switch control on the battery module.

When a total voltage of the battery module in the battery compartment is lower than a rated design voltage, a direct current converter may be configured in the power compartment to boost the voltage. The direct current converter may include a third input port and a third output port, the first output port is electrically connected to the third input port, and the third output port is electrically connected to the second input port, so that the cluster control box, the power conversion system, and the direct current converter may be connected in series, and the cluster control box controls the power conversion system and the direct current converter. In addition, because wiring of the power modules may be directly performed in the power compartment, the wiring of the power modules may be convenient.

In addition, a junction box may be disposed on the power conversion system, and the junction box is disposed with three-phase four-wire.

In an implementation, the junction box is located at one end of the power conversion system, the power conversion system is located above the cluster control box in the height direction of the cabinet body, a length of the power conversion system is greater than a length of the cluster control box in a length direction of the cabinet body, and the junction box and the cluster control box are disposed in a staggered manner.

In another implementation, the power conversion system, the direct current converter, and the cluster control box are disposed side by side in the height direction of the cabinet body. The direct current converter is disposed between the power conversion system and the cluster control box, the length of the power conversion system, in the length direction of the cabinet body, is greater than the length of the cluster control box, and is also greater than a length of the direct current converter, and the junction box, the direct current converter, and the cluster control box are disposed in a staggered manner, so that the junction box can be prevented from blocking the direct current converter and the cluster control box, to facilitate maintenance of the direct current converter and the cluster control box.

Because combustible gas is generated when thermal runaway occurs in the battery module, the combustible gas has a high risk of burning and explosion. To ensure safety of the energy storage system, the combustible gas may be discharged to the outside of the cabinet. Specifically, the battery module may include a module housing and an air guide pipe, an explosion-proof valve may be disposed on the module housing, and the air guide pipe may communicate with the module housing by using the explosion-proof valve. In addition, a smoke exhaust pipe and a smoke exhaust vent may be further disposed on the cabinet, the smoke exhaust pipe has an exhaust hole, the air guide pipe communicates with the smoke exhaust pipe, and the exhaust hole communicates with the smoke exhaust vent. In this way, a smoke exhaust channel may be formed between the battery module and the cabinet, so that the combustible gas generated by the battery module is discharged to the smoke exhaust pipe through the air guide pipe, and then is discharged to the outside of the cabinet, to reduce a concentration of the combustible gas in the cabinet, and prevent oxygen from entering the cabinet, thereby reducing the risk of burning and explosion.

In addition, when the thermal runaway occurs in the battery module, a temperature of the battery module increases. To cool the battery module, a water fire extinguishing system may be further disposed in the energy storage system. The water fire extinguishing system may include a main fire extinguishing pipe, and the main fire extinguishing pipe has a water inlet and a nozzle. The water inlet may be provided on the bottom wall of the cabinet, to facilitate a connection between the water inlet and an external water source. In addition, an outlet of the nozzle may be provided towards the battery module, so that water entering the main fire extinguishing pipe from the water inlet may be sprayed to the battery module through the nozzle, to cool the battery module, and a burning point of the combustible gas can be reduced, thereby reducing a risk of burning.

If excessive combustible gas is generated in the battery module, some of the gas may leak into the cabinet. To discharge the combustible gas inside the cabinet, a ventilation air outlet area and a ventilation air inlet area may be provided on the cabinet door. The ventilation air outlet area has an air outlet hole, and an air outlet may pass through the cabinet door in the direction from the outside of the cabinet body to the inside of the cabinet body. Similarly, the ventilation air inlet area may have an air inlet hole, and the air inlet hole passes through the cabinet door in the direction from the outside of the cabinet body to the inside of the cabinet body.

In addition, specific positions at which the ventilation air outlet area and the ventilation air inlet area are disposed on the cabinet door are not limited in this application. For example, the ventilation air outlet area and the ventilation air inlet area may be located on a same side of the cabinet door, and the ventilation air outlet area and the ventilation air inlet area are disposed at an interval, to prevent high-temperature gas discharged from the ventilation air outlet area from entering the cabinet body through the ventilation air inlet area, so that ventilation efficiency of the cabinet body can be improved.

To implement ventilation of the cabinet body, the energy storage system may usually further include a fan, and an air outlet side of the fan may be disposed towards the ventilation air outlet area, so that gas inside the cabinet can be discharged from the ventilation air outlet area to the outside of the cabinet, and air outside the cabinet can enter the inside of the cabinet from the ventilation air inlet area, to implement ventilation inside the cabinet.

In another possible implementation, an air inlet side of the fan may be further disposed towards the ventilation air inlet area. Alternatively, there may be at least two fans. In this way, an air outlet side of at least one fan may be disposed towards the ventilation air outlet area, and an air inlet side of at least one fan may be disposed towards the ventilation air inlet area. The fans all can implement ventilation inside the cabinet, to reduce the concentration of the combustible gas in the cabinet and reduce the risk of risk of burning and explosion of the cabinet.

The top wall of the cabinet may be further provided with an explosion relief window, so that when there is high concentration of the combustible gas inside the cabinet, and the concentration cannot be significantly reduced through ventilation described above, the explosion relief window may be opened, to discharge the combustible gas inside the cabinet from the explosion relief window.

In an implementation, the liquid cooling unit includes an internal circulation compartment and an external circulation compartment; the internal circulation compartment and the external circulation compartment are separated from each other; the internal circulation compartment is stacked on the external circulation compartment in the height direction of the cabinet body, in other words, the internal circulation compartment is located above the external circulation compartment; the internal circulation compartment communicates with the cabinet body; and the external circulation compartment communicates with the outside of the energy storage cabinet. The internal circulation compartment and the external circulation compartment are separated from each other, so that components in the liquid cooling unit are disposed in different regions for ease of maintenance. In addition, external gas is prevented from entering the inside of the cabinet body, to improve working stability of a battery pack or a power converter in the cabinet body.

In an implementation, the cabinet door is connected to the cabinet body in a width direction of the cabinet door by using a hinge structure, the internal circulation compartment includes a liquid cooling terminal interface group, the liquid cooling terminal interface group is arranged on a side that is of the internal circulation compartment and that faces the hinge structure, and the liquid cooling terminal interface group is configured to communicate with the first liquid outlet pipe and the first liquid return pipe.

In an implementation, the cabinet door is connected to the cabinet body in a width direction of the cabinet door by using a hinge structure, the internal circulation compartment includes a liquid cooling terminal interface group, the liquid cooling terminal interface group is arranged on a side that is of the internal circulation compartment and that faces the hinge structure, and the liquid cooling terminal interface group is configured to communicate with the first liquid outlet pipe, the first liquid return pipe, the second liquid outlet pipe, and the second liquid return pipe.

In an implementation, the internal circulation compartment is configured to accommodate an electronic control apparatus, a valve body assembly, a compressor, a condensation plate heat exchanger, and a dehumidification module, the electronic control apparatus is electrically connected to the compressor, the valve body assembly, and the dehumidification module, the valve body assembly separately communicates with the liquid cooling terminal interface group, the compressor, the condensation plate heat exchanger, and the dehumidification module, and the condensation plate heat exchanger is configured to provide a cold source for the dehumidification module.

In an implementation, the compressor and the electronic control apparatus are disposed at an interval in the height direction of the cabinet door, the compressor and the condensation plate heat exchanger are disposed at an interval in the width direction of the cabinet door, the dehumidification module is located between the compressor and the condensation plate heat exchanger, and the valve body assembly and the condensation plate heat exchanger are disposed at an interval in a direction perpendicular to the height direction of the cabinet body and a width direction of the cabinet body; and

the compressor is disposed at a bottom of the internal circulation compartment, the electronic control apparatus is disposed at a top of the internal circulation compartment, and the compressor and the electronic control apparatus are located on a left side of the internal circulation compartment in the width direction of the cabinet door.

In an implementation, the internal circulation compartment includes a first maintenance window and a second maintenance window, the first maintenance window and the second maintenance window are provided at an interval in the height direction of the cabinet door, and the first maintenance window and the second maintenance window are provided on a left side of the cabinet door in the width direction of the cabinet door.

In an implementation, the external circulation compartment is configured to accommodate an outdoor heat exchanger and at least one heat exchange fan, and the outdoor heat exchanger is configured to exchange heat with the outside of the energy storage cabinet.

In an implementation, the heat exchange fan is disposed above the outdoor heat exchanger in the height direction of the cabinet door.

In an implementation, the external circulation compartment further includes an air guide shutter and a filter screen, and the air guide shutter and the filter screen are disposed on a side that is of the external circulation compartment and that faces the cabinet door.

In an implementation, the liquid cooling unit includes a main frame, a first cover plate, a second cover plate, and a partition plate, and the main frame is mounted on the cabinet door; and the main frame includes a first side plate, a second side plate, a third side plate, and a fourth side plate that are sequentially connected head to tail, one end of the partition plate is connected to the first side plate and the other end of the partition plate is connected to the third side plate in the width direction of the cabinet door, the first cover plate is located on a side that is of the main frame and that faces the cabinet body, the first cover plate covers the side that is of the main frame and that faces the cabinet body, the second cover plate is located on a side that is of the main frame and that faces the cabinet door, and the second cover plate covers a part between the partition plate and the second side plate.

In an implementation, a side that is of the cabinet door and that is away from the cabinet body is provided with a mounting opening, the mounting opening is configured to mount the liquid cooling unit, and a protective net is disposed on the mounting opening.

In an implementation, when the cabinet door covers the cabinet body, the liquid cooling unit overlaps a part of the cabinet body in a projection of a plane that is perpendicular to the height direction of the cabinet body.

According to a second aspect, this application further provides a power-consuming apparatus. The power-consuming apparatus may include power-consuming equipment and the energy storage system in the first aspect, and the power-consuming equipment may be electrically connected to the energy storage system, so that the energy storage system can be configured to supply power to the power-consuming equipment. Because the energy storage system of the power-consuming apparatus has high integration and a small volume, the energy storage system may help reduce a floor area of the power-consuming apparatus.

According to a third aspect, this application provides an energy storage system with a door-mounted liquid cooling unit. The energy storage system with a door-mounted liquid cooling unit includes an energy storage cabinet and a liquid cooling unit, the energy storage cabinet is configured to accommodate the liquid cooling unit and at least one of a battery pack and a power converter, the energy storage cabinet includes a cabinet body and a cabinet door, the cabinet door is configured to cover the cabinet body, the cabinet body is configured to fasten at least one of the battery pack or the power converter, and the liquid cooling unit is fastened to a side that is of the cabinet door and that faces the battery pack or the power converter. Specifically, the liquid cooling unit is fastened to the cabinet door, and independent space for mounting the liquid cooling unit does not need to be provided in the cabinet body, so that the liquid cooling unit occupies small space of the cabinet body, to improve space utilization of the cabinet body.

In an embodiment, the liquid cooling unit includes an internal circulation compartment and an external circulation compartment; the internal circulation compartment and the external circulation compartment are separated from each other; the internal circulation compartment is stacked on the external circulation compartment in a height direction of the cabinet body, in other words, the internal circulation compartment is located above the external circulation compartment; the internal circulation compartment communicates with the cabinet body; and the external circulation compartment communicates with an outside of the energy storage cabinet. The internal circulation compartment and the external circulation compartment are separated from each other, so that components in the liquid cooling unit are disposed in different regions for ease of maintenance. In addition, external gas is prevented from entering the inside of the cabinet body, to improve working stability of a battery pack or a power converter in the cabinet body.

In an embodiment, the cabinet body is connected to the cabinet door in a width direction of the cabinet body by using a hinge structure, the internal circulation compartment includes a liquid cooling terminal interface group, the liquid cooling terminal interface group is arranged on a side that is of the internal circulation compartment and that faces the hinge structure, the liquid cooling terminal interface group is configured to communicate with at least one liquid cooling pipe group, and the at least one liquid cooling pipe group is configured to dissipate heat for the battery pack or the power converter. The liquid cooling pipe group is connected to the liquid cooling terminal interface group in a quick-plug manner, so that the battery pack or the power converter is conveniently connected to the liquid cooling unit, and convenience of connecting the battery pack or the power converter to the liquid cooling unit is improved.

In an embodiment, the internal circulation compartment is configured to accommodate an electronic control apparatus, a valve body assembly, a compressor, a condensation plate heat exchanger, and a dehumidification module, the electronic control apparatus is electrically connected to the compressor, the valve body assembly, and the dehumidification module, the valve body assembly further separately communicates with the liquid cooling terminal interface group, the compressor, the condensation plate heat exchanger, and the dehumidification module, and the condensation plate heat exchanger is configured to provide a cold source for the dehumidification module. In this manner, the dehumidification module can dehumidify gas in the cabinet body, the condensation plate heat exchanger provides the cold source for the dehumidification module, and an independent cold source for serving the dehumidification module is not needed. This simplifies a structure of the liquid cooling unit, and can further reduce costs of the liquid cooling unit.

It should be noted that the internal circulation compartment is further configured to accommodate an evaporation plate heat exchanger, a first water pump, and a second water pump, and the evaporation plate heat exchanger, the first water pump, and the second water pump all communicate with the valve body assembly.

In an embodiment, the compressor and the electronic control apparatus are disposed at an interval in a height direction of the cabinet door, the compressor and the condensation plate heat exchanger are disposed at an interval in the width direction of the cabinet door, the dehumidification module is disposed between the compressor and the condensation plate heat exchanger, and the valve body assembly and the condensation plate heat exchanger are disposed at an interval in a direction perpendicular to the height direction of the cabinet body and the width direction of the cabinet body; and the compressor is disposed at a bottom of the internal circulation compartment, the electronic control apparatus is disposed at a top of the internal circulation compartment, and the compressor and the electronic control apparatus are located on a left side of the internal circulation compartment in the width direction of the cabinet body.

More specifically, the internal circulation compartment further includes a first maintenance window and a second maintenance window, the first maintenance window and the second maintenance window are provided at an interval in the height direction of the cabinet door, and the first maintenance window and the second maintenance window are provided on a left side of the cabinet door in the width direction of the cabinet door. In this disposition manner, the first maintenance window corresponds to the electronic control apparatus, and the second maintenance window corresponds to the compressor, to facilitate maintenance of the electronic control apparatus and the compressor.

In an embodiment, the external circulation compartment is configured to accommodate an outdoor heat exchanger and at least one heat exchange fan, and the outdoor heat exchanger is configured to exchange heat with the outside of the energy storage cabinet. Gas outside the energy storage cabinet enters the external circulation compartment passing through the outdoor heat exchanger, and flows out of the external circulation compartment through the heat exchange fan. The outdoor heat exchanger communicates with the valve body assembly. A quantity of heat exchange fans is set based on an actual requirement.

When a temperature of the battery pack and/or a temperature of the power converter are/is excessively high, a high-temperature refrigerant in the battery pack and/or a high-temperature refrigerant in the power converter communicate/communicates with the liquid cooling terminal interface group through the liquid cooling pipe group, and then communicate/communicates with the valve body assembly, the evaporation plate heat exchanger, the condensation plate heat exchanger, the compressor, the dehumidification module, the first water pump, and the second water pump, to reduce temperatures of the high-temperature refrigerants, and reduce the temperatures of the battery pack and the power converter. The outdoor heat exchanger exchanges heat with the gas outside the energy storage cabinet, and transports a low-temperature refrigerant to the valve body assembly. When air humidity in the energy storage cabinet is excessively high, a dehumidification apparatus sucks the gas in the energy storage cabinet into the internal circulation compartment, dehumidifies the sucked gas, and discharges dehumidified gas from the internal circulation compartment back to the energy storage cabinet, to dehumidify the energy storage cabinet, thereby improving working stability of an energy storage battery and a power module.

When the heat exchange fan and the outdoor heat exchanger are specifically disposed, the heat exchange fan is disposed above the outdoor heat exchanger in the height direction of the cabinet door. In addition, to ensure that the gas flowing through the heat exchange fan to the outside of the external circulation compartment does not flow back, and prevent a large-granularity impurity from entering the outdoor heat exchanger, the liquid cooling unit further includes an air guide shutter and a filter screen. Both the air guide shutter and the filter screen are detachably mounted in the external circulation compartment. The air guide shutter corresponds to at least one heat exchange fan, and the filter screen corresponds to the outdoor heat exchanger.

In an embodiment, the liquid cooling unit includes a main frame, a first cover plate, a second cover plate, and a partition plate, and the main frame is mounted on the cabinet door; and the main frame includes a first side plate, a second side plate, a third side plate, and a fourth side plate that are sequentially connected head to tail, one end of the partition plate is connected to the first side plate and the other end of the partition plate is connected to the third side plate in the width direction of the cabinet door, the first cover plate is located on a side that is of the main frame and that faces the cabinet body, the first cover plate covers the side that is of the main frame and that faces the cabinet body, the second cover plate is located on a side that is of the main frame and that faces the cabinet door, and the second cover plate covers a part between the partition plate and the second side plate. Specifically, in the width direction of the cabinet body, the first side plate is disposed on a left side, and the foregoing liquid cooling terminal interface group is disposed on the third side plate. In addition, the partition plate, the first cover plate, the first side plate, the third side plate, and the fourth side plate form the external circulation compartment. The partition plate, the first cover plate, the second cover plate, the first side plate, the second side plate, and the third side plate form the internal circulation compartment.

It should be noted that the first side plate is provided with a first opening and a second opening; the first opening and the second opening are located between the partition plate and the second side plate; the first opening is provided on a side that is of the first side plate and that is close to the second side plate, so that the first opening corresponds to the electronic control apparatus; and the second opening is provided on a side that is of the first side plate and that is close to the partition plate, so that the second opening corresponds to the compressor.

In an embodiment, a side that is of the cabinet door and that is away from the cabinet body is provided with a mounting opening, the liquid cooling unit is mounted on the mounting opening, and a protective net is mounted on the mounting opening. This facilitates mounting of the liquid cooling unit on the cabinet door, and prevents an impurity from entering the external circulation compartment.

In an embodiment, the cabinet body includes the battery pack and the power converter, and the battery pack is located above the power converter in the height direction of the cabinet body. In some other embodiments, the power converter is located above the battery pack in the height direction of the cabinet body.

In an embodiment, when the cabinet door covers the cabinet body, the liquid cooling unit overlaps a part of the cabinet body in a projection of a plane that is perpendicular to the height direction of the cabinet body. In this way, when the cabinet door is closed, a part of the liquid cooling unit is located in the cabinet body. Compared with that the liquid cooling unit is completely disposed in the cabinet body, or an independent chamber is disposed in the cabinet body to mount the liquid cooling unit, space occupied by the liquid cooling unit in the cabinet body can be reduced.

According to a fourth aspect, this application further provides a door-mounted liquid cooling unit. The liquid cooling unit includes a main frame, an internal circulation compartment, and an external circulation compartment, the internal circulation compartment and the external circulation compartment are disposed on the main frame, the internal circulation compartment and the external circulation compartment are separated from each other, the internal circulation compartment is configured to accommodate a liquid cooling terminal interface group, a valve body assembly, a compressor, a condensation plate heat exchanger, and a dehumidification module, the compressor, the condensation plate heat exchanger, and the dehumidification module are arranged sequentially and at intervals in a width direction of the main frame, the dehumidification module is located between the compressor and the condensation plate heat exchanger, the external circulation compartment is configured to accommodate an outdoor heat exchanger and at least one heat exchange fan, the heat exchange fan is located above the outdoor heat exchanger in a height direction of the main frame, the liquid cooling terminal interface group is arranged on a side wall of the internal circulation compartment, the liquid cooling terminal interface group is further configured to be connected to a liquid cooling pipe group, and the valve body assembly communicates with the compressor, the condensation plate heat exchanger, the dehumidification module, and the outdoor heat exchanger. The door-mounted liquid cooling unit is connected to a cabinet door by using the main frame, to improve mounting convenience. This occupies small or no space of a cabinet body connected to the cabinet door, and improves space utilization of the cabinet body. In addition, the liquid cooling pipe group is inserted into the liquid cooling terminal interface group through the liquid cooling pipe group, so that the liquid cooling unit is conveniently connected to a to-be-heat-exchanged component, to improve convenience of the liquid cooling unit.

### BRIEF DESCRIPTION OF DRAWINGS

FIG. 1 is a diagram of a structure of an energy storage system according to an embodiment of this application;
FIG. 2 is a diagram of a structure of a cabinet door according to an embodiment of this application;
FIG. 3 is a diagram of a structure of an energy storage system when a cabinet door is opened relative to a cabinet body according to an embodiment of this application;
FIG. 4 is a diagram of a structure of a liquid cooling unit according to an embodiment of this application;
FIG. 5 is a diagram of a structure in which at least two battery modules are connected according to an embodiment of this application;
FIG. 6 is a diagram of a partial structure of an energy storage system according to an embodiment of this application;
FIG. 7 is a diagram of a structure in which a PCS, a DCDC, and a cluster control box are connected according to an embodiment of this application;
FIG. 8 is a sectional view of a top view of an energy storage system according to an embodiment of this application;
FIG. 9 is a diagram of another partial structure of an energy storage system according to an embodiment of this application;
FIG. 10 is a diagram of a structure of an energy storage system according to an embodiment of this application;
FIG. 11 is a diagram of gas circulation of a liquid cooling unit in an energy storage system according to an embodiment of this application;
FIG. 12 is a diagram of a structure of an energy storage system according to an embodiment of this application;
FIG. 13 is a diagram of a structure of a liquid cooling unit according to an embodiment of this application;
FIG. 14 is a diagram of a structure of performing heat exchange on an energy storage cabinet by a liquid cooling unit according to an embodiment of this application;
FIG. 15 is a diagram of a structure of performing heat exchange and dehumidification on an energy storage cabinet by a liquid cooling unit according to an embodiment of this application;
FIG. 16 is a diagram of another structure of performing heat exchange on an energy storage cabinet by a liquid cooling unit according to an embodiment of this application;
FIG. 17a is a diagram of another structure of a liquid cooling unit according to an embodiment of this application; and
FIG. 17b is a main view of a first cover body in FIG. 17a.

### Reference numerals:

1: cabinet; 101: cabinet body; 1011: battery compartment; 10111: battery module; 101111: first total electrode;
101112: second total electrode; 10111a: first liquid inlet; 10111b: first liquid outlet; 101113: module housing;
101114: air guide pipe; 101115: explosion-proof valve; 1012: power compartment; 10121: power module; 101211: cluster control box;
1012111: first output port; 1012112: first input port; 10121121: first electrode interface;
10121122: second electrode interface; 101212: PCS; 1012121: second output port;
1012122: second input port; 1012123: junction box; 1012124: three-phase four-wire;
101213: DCDC; 1012131: third output port; 1012132: third input port;
10121a: second liquid inlet; 10121b: second liquid outlet; 1013: explosion relief window;
102: cabinet door; 1021: door lock; 1022: ventilation air outlet area; 1023: ventilation air inlet area; 1024: cooling area;
1025: emergency stop switch box; 1026: door lamp; 103: smoke exhaust pipe;
2: liquid cooling unit; 201: unit housing; 202: flange edge; 203: first liquid outlet pipe; 2031: first liquid outlet branch;
2032: first stop valve; 204: first liquid return pipe; 2041: first liquid return branch; 2042: second stop valve;
205: second liquid outlet pipe; 2051: second liquid outlet branch; 2052: third stop valve; 206: second liquid return pipe;
2061: second liquid return branch; 2062: fourth stop valve;
3: water fire extinguishing system; 301: main fire extinguishing pipe; 3011: water inlet; 3012: nozzle;
10: energy storage cabinet; 11: cabinet body; 12: cabinet door; 120: protective net; 13: battery pack; 14: power converter; 20: liquid cooling unit; 21: internal circulation compartment; 210: liquid cooling terminal interface group; 211: first side plate; 2110: first maintenance window; 2111: second maintenance window; 212: second side plate; 213: third side plate; 214: fourth side plate; 215: first cover plate; 2151: air inlet; 2152: air outlet; 216: second cover plate; 217: partition plate; 22: external circulation compartment; 30: hinge structure; 40: liquid cooling pipe group; 50: air guide shutter; 60: filter screen; 2101: electronic control apparatus; 2102: valve body assembly; 2103: compressor; 2104: condensation plate heat exchanger; 1040: third heat exchange part; 1041: fourth heat exchange part; 105: evaporation plate heat exchanger; 1050: first heat exchange part; 1051: second heat exchange part; 106: dehumidification module; 1060: dehumidification evaporator; 1061: dehumidification fan; 107: first water pump; 108: second water pump; 109: integrated plate; 110: outdoor heat exchanger; 111: heat exchange fan; 112: first valve body; 113: second valve body.

### DESCRIPTION OF EMBODIMENTS

To make objectives, technical solutions, and advantages of this application clearer, the following further describes this application in detail with reference to accompanying drawings.

Terms used in the following embodiments are merely intended to describe specific embodiments, but are not intended to limit this application. The terms "one", "a", "the", "the foregoing", "this", and "the one" of singular forms used in this specification and the appended claims of this application are also intended to include expressions such as "one or more", unless otherwise specified in the context clearly.

Reference to "an embodiment", "a specific embodiment", or the like described in this specification means that one or more embodiments of this application include a specific feature, structure, or characteristic described with reference to this embodiment. The terms "include", "comprise", "have", and their variants all mean "include but are not limited to", unless otherwise specifically emphasized in another manner.

For ease of understanding of the energy storage system provided in embodiments of this application, the following first describes an application scenario of the energy storage system. The energy storage system is a system that can store electric energy by using a specific medium and release the stored energy to generate electricity when necessary. The energy storage system may be used as a load balancing apparatus and a backup power supply and applied to a scenario such as an industrial and commercial park, a large-scale ground power supply station, or a photovoltaic energy storage system. Application of the energy storage system is briefly described by using a scenario of a photovoltaic energy storage system as an example. The photovoltaic energy storage system may usually include a photovoltaic module, a power conversion system, an energy storage system, and a grid-connected inverter. The photovoltaic module may convert light energy into electric energy in a form of a direct current, and output the electric energy to the grid-connected inverter. The grid-connected inverter may convert the electric energy in the form of the direct current into electric energy in a form of an alternating current, and transmit the electric energy in the form of the alternating current to a power grid, to implement grid-connection of the optical storage system. When the electric energy generated by the photovoltaic module exceeds a requirement of the power grid for electric energy, the energy storage system may store a part of the electric energy output by the photovoltaic inverter; and when the electric energy output by the photovoltaic module cannot meet the requirement of the power grid for electric energy, output the stored electric energy to the power grid, to provide a more stable direct current source for the power grid. The power conversion system may convert a power grid voltage into a power supply voltage of the energy storage system; or convert a voltage stored in the energy storage system into a power grid voltage, and output the power grid voltage to the power grid.

In addition, energy storage systems may be classified into module-level energy storage systems, cabinet-level energy storage systems, and container-level energy storage systems based on power consumption requirements in different application scenarios of the energy storage systems. In a current energy storage system, a cabinet of the energy storage system is usually designed with separate compartments. For example, a battery compartment, a power compartment, and a temperature control compartment are separated. In addition, in an existing energy storage system, it is further considered that some power modules are disposed outside a cabinet. Therefore, an independent accommodating apparatus needs to be disposed outside the cabinet for these power modules. However, this makes a structure of the energy storage system complex, and costs are high.

To resolve the foregoing problem, in the energy storage system provided in this application, a layout of modules inside the cabinet is optimized, so that all power modules can be accommodated in a same cabinet, to improve an integrated design of the energy storage system. To facilitate understanding of the energy storage system provided in embodiments of this application, the following describes a specific structure of the energy storage system in detail with reference to the accompanying drawings.

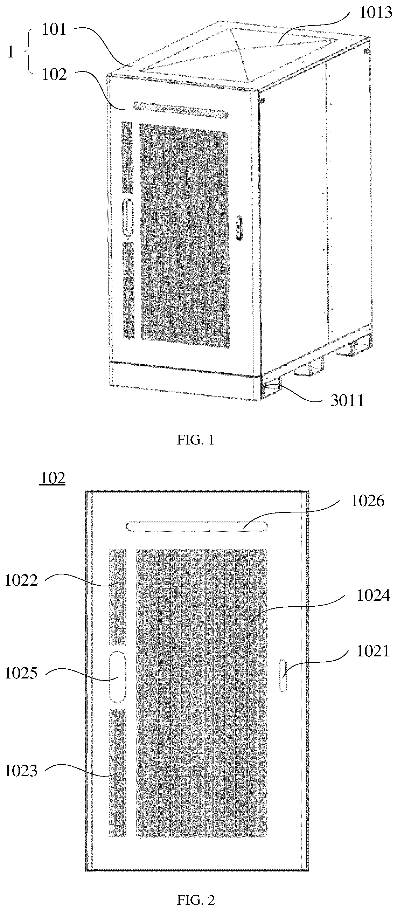

First, FIG. 1 is a diagram of a structure of an energy storage system according to an embodiment of this application. The energy storage system may include a cabinet 1, and the cabinet 1 includes a cabinet body 101 and a cabinet door 102. The cabinet door 102 may be in a hinged connection to the cabinet body 101, to be specific, the cabinet door 102 may be connected to the cabinet body 101 through a hinged connection shaft, and the cabinet door 102 may rotate around the hinged connection shaft, to implement opening or closing of the cabinet door 102 relative to the cabinet body 101.

In this application, a shape of the cabinet body 101 is not specifically limited. For example, the cabinet body 101 may be a cuboid shape shown in FIG. 1. The cuboid-shaped cabinet body 101 may include six side walls: a first side wall, a second side wall, a third side wall, a fourth side wall, a fifth side wall, and a sixth side wall respectively. The first side wall and the second side wall are disposed opposite to each other, the third side wall and the fourth side wall are disposed opposite to each other, and the fifth side wall and the sixth side wall are disposed opposite to each other. In this application, a direction from the first side wall to the second side wall may be defined as a first direction, a direction from the third side wall to the fourth side wall may be defined as a second direction, and a direction from the fifth side wall to the sixth side wall may be defined as a third direction.

In addition, in this application, the first side wall may be a front side wall. When the energy storage system is disposed in an application scenario of the front side wall, the front side wall may be disposed towards a user. In the energy storage system shown in FIG. 1, the cabinet door 102 may be used as a first side wall. In this way, a size of the cabinet door 102 may be large, so that when the cabinet door 102 is opened relative to the cabinet body 101, maintenance of an internal structure of the cabinet body 101 can be facilitated.

When the first side wall is a front side wall, the second side wall may be a rear side wall. In addition, the third side wall may be a left side wall, the fourth side wall may be a right side wall, the fifth side wall may be a top wall, and the sixth side wall may be a bottom wall. Based on this, in this application, the first direction may be a width direction of the cabinet body 101, the second direction may be a length direction of the cabinet body 101, and the third direction may be a height direction of the cabinet body 101. Usually, when the energy storage system is in normal use, the cabinet body 101 may be placed on the ground along the height direction of the cabinet body 101.

Still refer to FIG. 1. In the energy storage system provided in this application, the cabinet body 101 may be further provided with an explosion relief window 1013, and the explosion relief window 1013 may be, for example, disposed on the top wall of the cabinet body 101. When atmospheric pressure in the cabinet body 101 is high, the explosion relief window 1013 may be opened, so that gas is discharged from the explosion relief window 1013, and explosion relief on the cabinet 1 can be implemented, thereby ensuring safety of the cabinet 1.

FIG. 2 is a diagram of a structure of the cabinet door 102 according to an embodiment of this application. A door lock 1021 may be disposed on the cabinet door 102. A user may hold the door lock 1021 to open or close the cabinet door 102 relative to the cabinet body 101; or when the cabinet door 102 is in a closed state relative to the cabinet body 101, may lock the door lock 1021, to avoid opening or closing the cabinet door 102 by mistake when the energy storage system is in a working state, so that safety of the energy storage system can be improved.

In addition, the cabinet door 102 may further be provided with a ventilation air outlet area 1022 and a ventilation air inlet area 1023. Refer to FIG. 1 and FIG. 2. Gas inside the cabinet body 101 may be discharged from the ventilation air outlet area 1022 to the outside of the cabinet body 101, and air outside the cabinet body 101 may enter the inside of the cabinet body 101 from the ventilation air inlet area 1023, to implement ventilation inside the cabinet body 101.

It may be understood that, to enable the gas inside the cabinet body 101 to be discharged from the ventilation air outlet area 1022 to the outside of the cabinet body 101, the ventilation air outlet area 1022 may be provided with an air outlet hole (not shown in FIG. 2), and the air outlet hole may pass through the cabinet door 102 in a direction from the inside of the cabinet body 101 to the outside of the cabinet body 101. A shape of the air outlet hole is not specifically limited in this application. For example, the air outlet hole may be a regular shape such as a circular hole or a square hole, or may be some possible irregular shapes. In this application, an aperture of the air outlet hole may be set to be small, so that the gas inside the cabinet body 101 can be discharged from the air outlet hole, and dust, rain, or the like entering the inside of the cabinet body 101 can be further reduced, thereby improving reliability of the energy storage system. In addition, a quantity of air outlet holes is not limited in this application. For example, there may be a plurality of air outlet holes, to improve air outlet efficiency of the ventilation air outlet area 1022.

Similarly, the ventilation air inlet area 1023 may be provided with an air inlet hole, and the air inlet hole may pass through the cabinet door 102 in the direction from the inside of the cabinet body 101 to the outside of the cabinet body 101. A shape of the air inlet hole is not specifically limited in this application, and an aperture of the air inlet hole may also be set to be small. In addition, there may be a plurality of air inlet holes, and this is not limited in this application.

In this application, specific positions at which the ventilation air outlet area 1022 and the ventilation air inlet area 1023 are disposed are not limited. For example, in the cabinet door 102 shown in FIG. 2, the ventilation air outlet area 1022 and the ventilation air inlet area 1023 may be provided on a same side of the cabinet door 102, and the ventilation air outlet area 1022 and the ventilation air inlet area 1023 may be provided side by side in the height direction of the cabinet body 101. It may be understood that, to ensure ventilation efficiency of the cabinet body 101, the ventilation air outlet area 1022 and the ventilation air inlet area 1023 may be provided at an interval, to prevent high-temperature gas discharged from the ventilation air outlet area 1022 from entering the cabinet body 101 through the ventilation air inlet area 1023.

It should be noted that, to implement ventilation inside the cabinet body 101, the energy storage system may further include a fan (not shown in FIG. 1). The fan may be disposed on the cabinet body 101, and an air outlet side of the fan may be disposed towards the ventilation air outlet area 1022, or an air inlet side of the fan may be disposed towards the ventilation air inlet area 1023. Alternatively, there may be at least two fans. In this way, an air outlet side of at least one fan may be disposed towards the ventilation air outlet area 1022, and an air inlet side of at least one fan may be disposed towards the ventilation air inlet area 1023.

Still refer to FIG. 2. The cabinet door 102 may be further provided with a cooling area 1024. The cooling area 1024 may be provided with a ventilation hole, and the ventilation hole may pass through the cabinet door 102 in the direction from the inside of the cabinet body 101 to the outside of the cabinet body 101. A shape of the ventilation hole is not specifically limited in this application. For example, the ventilation hole may be a regular shape such as a circular hole or a square hole, or may be some possible irregular shapes. In this application, an aperture of the ventilation hole may be set to be small, so that the gas inside the cabinet body 101 can be discharged from the ventilation hole, and dust, rain, or the like entering the inside of the cabinet body 101 can be further reduced, thereby improving reliability of the energy storage system. In addition, a quantity of ventilation holes is not limited in this application. For example, there may be a plurality of ventilation holes, to improve ventilation efficiency of the cooling area 1024.

In addition to the foregoing structure, some other possible structures may be further disposed on the cabinet door 102. For example, still refer to FIG. 2. An emergency stop switch box 1025 may be further disposed on the cabinet door 102, so that in an emergency case such as a fault in the energy storage system, the energy storage system stops working by using the emergency stop switch box 1025. In addition, a door lamp 1026 may be further disposed on the cabinet door 102, to perform lighting by using the door lamp 1026 when the energy storage system is in an environment with poor light, to facilitate operation or maintenance of the energy storage system.

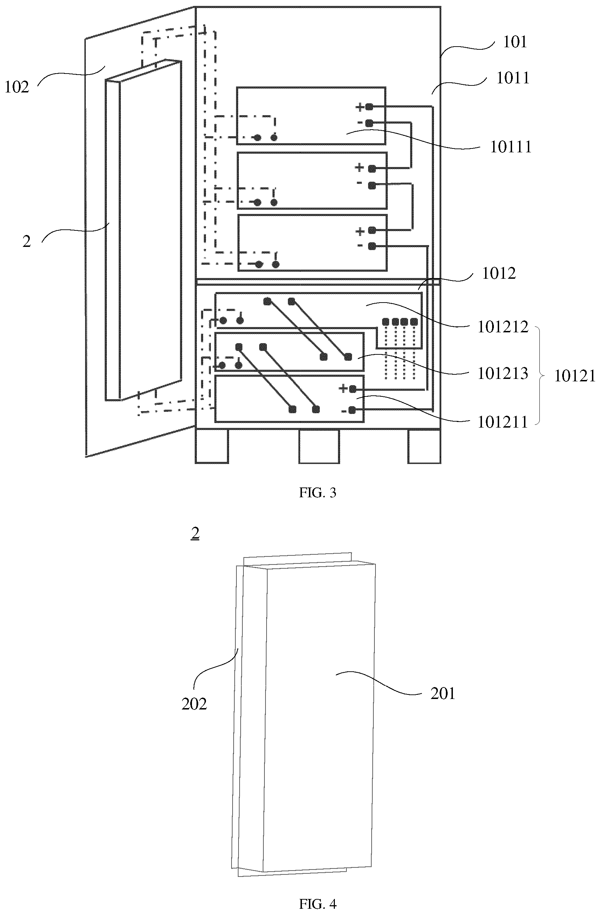

In addition, FIG. 3 is a diagram of a structure of the energy storage system when the cabinet door 102 is opened relative to the cabinet body 101. The energy storage system may be used to show a manner of disposing the internal structure of the cabinet body 101. Specifically, the energy storage system may further include a liquid cooling unit 2. With reference to FIG. 1 and FIG. 3 together, it may be learned that when the cabinet door 102 is in a closed state relative to the cabinet body 101, the liquid cooling unit 2 may be disposed on a side that is of the cabinet door 102 and that faces the cabinet body 101.

When the liquid cooling unit 2 is specifically disposed on the cabinet door 102, refer to FIG. 4. FIG. 4 is a diagram of a structure of the liquid cooling unit 2 according to an embodiment of this application. The liquid cooling unit 2 may include a unit housing 201, and a flange edge 202 may be disposed on a peripheral side of the unit housing 201. With reference to FIG. 3 and FIG. 4 together, the flange edge 202 may be disposed on a peripheral side of an edge that is of the unit housing 201 and that is disposed towards the cabinet door 102. In this way, when the liquid cooling unit 2 is disposed on the cabinet door 102, the flange edge 202 may be attached to the cabinet door 102, so that the flange edge 202 may be fastened to the cabinet door 102 by using a fastener such as a screw.

The foregoing manner of connecting the liquid cooling unit 2 to the cabinet door 102 is merely an example for description in this application. In this embodiment of this application, the liquid cooling unit 2 may be fastened to the cabinet door 102 in another possible manner, and the manners are not enumerated herein.

In addition, a sealing ring (not shown in FIG. 3) may be further disposed between the unit housing 201 and the cabinet door 102, and the sealing ring may be disposed around the cooling area 1024. Therefore, when the liquid cooling unit 2 is connected to the cabinet door 102, the unit housing 201 may press the sealing ring towards the cabinet door 102, so that the sealing ring fills a gap between the unit housing 201 and the cabinet door 102 under extrusion effect of the unit housing 201 and the cabinet door 102, to implement sealing effect of the sealing ring. In this way, dust, rain, or the like entering the inside of the cabinet body 101 from the cooling area 1024 can be effectively reduced, thereby improving reliability of the energy storage system.

In this application, the liquid cooling unit 2 is disposed on the cabinet door 102, so that an internal structure of the cabinet 1 can be compact, thereby helping improve energy density of the energy storage system, improving utilization of internal space of the cabinet 1, and reducing a volume of the cabinet 1. In addition, because the cooling area 1024 of the cabinet door 102 and the liquid cooling unit 2 are both disposed on a same side of the cabinet 1 (for example, a front side wall side of the cabinet 1), that is, the liquid cooling unit 2 and an air inlet and an air outlet of an air duct used for heat dissipation of the liquid cooling unit 2 are both located on a same side of the cabinet 1. When a plurality of energy storage systems need to be disposed in parallel, rear side walls, left side walls, and right side walls of a plurality of cabinets 1 of the plurality of energy storage systems may be disposed in an attaching manner, so that the energy storage systems can be disposed more flexibly, and application scenarios of the energy storage systems are wider.

With reference to FIG. 2 and FIG. 3 together, a projection of the liquid cooling unit 2 on the cabinet door may overlap at least a part of the cooling area 1024 of the cabinet door 102, so that the liquid cooling unit 2 can be cooled when air outside the cabinet 1 enters the cabinet 1 through the ventilation hole of the cooling area 1024.

It may be understood that, to enable the air outside the cabinet 1 to enter the cabinet 1 through the ventilation hole of the cooling area 1024, an air inlet side of the fan mentioned above may also be disposed towards the cooling area 1024. In addition, still refer to FIG. 2 and FIG. 3. In this application, a set area of the cooling area 1024 may be designed based on an outline size of the unit housing 201 of the liquid cooling unit 2. For example, a projection of the unit housing 201 on the cabinet door 102 may fall within a contour range of the cooling area 1024, thereby helping improve cooling efficiency of the liquid cooling unit 2.

Still refer to FIG. 3. The cabinet body 101 may include a battery compartment 1011 and a power compartment 1012. The battery compartment 1011 and the power compartment 1012 may be disposed side by side, and may be arranged, for example, in the height direction of the cabinet body 101, thereby helping reduce a floor area of the cabinet 1.

When the battery compartment 1011 is specifically disposed, the battery module 10111 may be disposed in the battery compartment 1011. A quantity of battery modules 10111 in the battery compartment 1011 is not limited in this application. For example, there may be one or at least two battery modules 10111. When at least two battery modules 10111 are disposed in the battery compartment 1011, the at least two battery modules 10111 may be, but are not limited to, disposed side by side in the height direction of the cabinet 1.

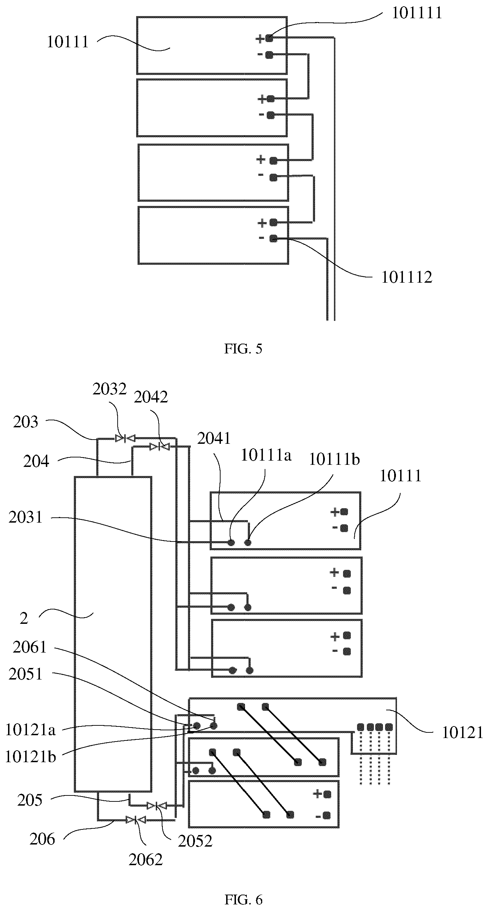

The at least two battery modules 10111 in the battery compartment 1011 may be connected in series. FIG. 5 is a diagram of a structure in which the at least two battery modules 10111 are connected. After the at least two battery modules 10111 are connected in series, a first total electrode 101111 and a second total electrode 101112 may be formed, and the first total electrode 101111 and the second total electrode 101112 may be electrically connected to another component.

In addition, the liquid cooling unit 2 mentioned above may cool the battery module 10111. During specific implementation, refer to FIG. 6. FIG. 6 is a diagram of a partial structure of the energy storage system according to an embodiment of this application. The battery module 10111 may include a first liquid inlet 10111a and a first liquid outlet 10111b, and the liquid cooling unit 2 may include a first liquid outlet pipe 203 and a first liquid return pipe 204. The first liquid outlet pipe 203 communicates with the first liquid inlet 10111a, and the first liquid return pipe 204 communicates with the first liquid outlet 10111b. In this way, a coolant in the liquid cooling unit 2 may enter the battery module 10111 from the first liquid outlet pipe 203 through the first liquid inlet 10111a, and the heated coolant in the battery module 10111 may flow back to the liquid cooling unit 2 from the first liquid outlet 10111b through the first liquid return pipe 204, so that a first cooling circulation loop may be formed between the liquid cooling unit 2 and the battery module 10111, to cool the battery module 10111 by circulating the coolant in the first cooling circulation loop.

Still refer to FIG. 6. When the at least two battery modules 10111 are disposed in the battery compartment 1011, to cool each battery module 10111, a first liquid outlet branch 2031 may be further disposed on the first liquid outlet pipe 203, and a first liquid return branch 2041 may be disposed on the first liquid return pipe 204. The first liquid outlet branch 2031 may be connected to the first liquid outlet pipe 203 by using a three-way valve, or the first liquid outlet branch 2031 is an elbow structure formed on the first liquid outlet pipe 203. The first liquid return branch 2041 may be connected to the first liquid return pipe 204 by using a three-way valve, or the first liquid return branch 2041 is an elbow structure formed on the first liquid return pipe 204.

It may be understood that a quantity of first liquid outlet branches 2031 and a quantity of first liquid return branches 2041 may be the same as a quantity of battery modules 10111, so that the first liquid outlet branch 2031 is disposed in a one-to-one correspondence with the battery module 10111, and the first liquid outlet branch 2031 communicates with the first liquid inlet 10111a of the battery module 10111 that is correspondingly disposed. Similarly, the first liquid return branch 2041 is also disposed in a one-to-one correspondence with the battery module 10111, and the first liquid return branch 2041 communicates with the first liquid outlet 10111b of the battery module 10111 that is correspondingly disposed.

In addition, still refer to FIG. 6. A first stop valve 2032 may be disposed on the first liquid outlet pipe 203. When the liquid cooling unit 2 or the battery module 10111 needs to be maintained or liquid needs to be replaced, the first stop valve 2032 may be closed, so that a liquid leakage phenomenon at the first liquid outlet pipe 203 can be avoided, to reduce a circuit fault caused by liquid leakage.

In this application, a specific type of the first stop valve 2032 is not limited. For example, the first stop valve 2032 may be a bidirectional stop valve. In this way, reliability of the first stop valve 2032 can be effectively improved. In addition, when the first liquid outlet branch 2031 is disposed on the first liquid outlet pipe 203, in a flow direction of the coolant, the first stop valve 2032 may be disposed on a part that is of the first liquid outlet pipe 203 and that is located before each first liquid outlet branch 2031. In this way, the coolant flowing through each first liquid outlet branch 2031 may be cut off by using one first stop valve 2032. This can help simplify the structure of the energy storage system.

Still refer to FIG. 6. A second stop valve 2042 may be disposed on the first liquid return pipe 204. When the liquid cooling unit 2 or the battery module 10111 is maintained or liquid is replaced, the second stop valve 2042 may also be closed, so that a liquid leakage phenomenon at the first liquid return pipe 204 can be avoided, to reduce a circuit fault caused by liquid leakage.

In this application, a specific type of the second stop valve 2042 is not limited. For example, the second stop valve 2042 may be a bidirectional stop valve. In this way, reliability of the second stop valve 2042 can be effectively improved. It may be understood that, when the first liquid return branch 2041 is disposed on the first liquid return pipe 204, in the flow direction of the coolant, the second stop valve 2042 may be disposed on a part that is of the first liquid return pipe 204 and that is located behind each first liquid return branch 2041. In this way, the coolant flowing out from each first liquid return branch 2041 may be cut off by using one second stop valve 2042. This can help simplify the structure of the energy storage system. In addition, when the first stop valve 2032 is disposed on the first liquid outlet pipe 203, and the second stop valve 2042 is disposed on the first liquid return pipe 204, a risk of liquid leakage in the entire first cooling circulation loop may be reduced, thereby reducing the circuit fault caused by liquid leakage.

Still refer to FIG. 3. When the power compartment 1012 is specifically disposed, a power module 10121 may be disposed in the power compartment 1012. There may be at least two power modules 10121, and the power modules 10121 may be specifically disposed based on specific application scenarios. For example, when a total voltage of the battery module 10111 in the battery compartment 1011 is lower than a rated designed voltage, a direct current converter (direct current, DCDC 101213) may be configured in the power compartment 1012 to boost the voltage.

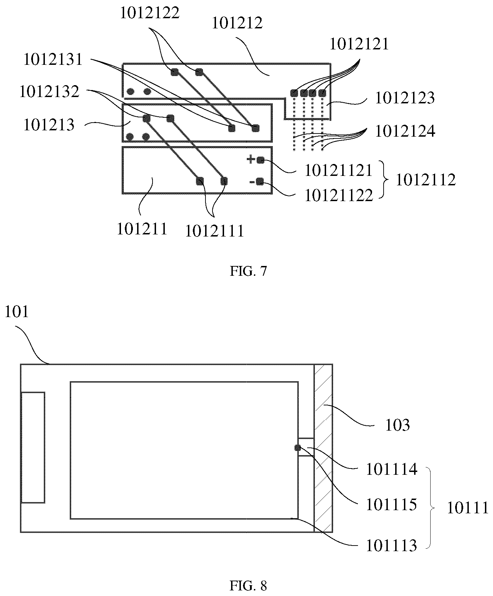

In addition, in the energy storage system shown in FIG. 3, the power module 10121 in the power compartment 1012 may further include a cluster control box 101211 and a power conversion system (power conversion system, PCS 101212). FIG. 7 is a diagram of a structure in which the PCS 101212, the DCDC 101213, and the cluster control box 101211 are connected. The cluster control box 101211 has a first output port 1012111 and a first input port 1012112, the PCS 101212 has a second output port 1012121 and a second input port 1012122, and the DCDC 101213 has a third output port 1012131 and a third input port 1012132. Therefore, the first output port 1012111 of the cluster control box 101211 may be electrically connected to the third input port 1012132 of the DCDC 101213, the third output port 1012131 of the DCDC 101213 may be electrically connected to the second input port 1012122 of the PCS 101212. In addition, a junction box 1012123 may be disposed on the second output port 1012121 of the PCS 101212, and the junction box 1012123 may be disposed with three-phase four-wire 1012124, so that three-phase four-wire electricity can be output.

Still refer to FIG. 7. The first input port 1012112 of the cluster control box 101211 may include a first electrode interface 10121121 and a second electrode interface 10121122. In this case, the first total electrode 101111 formed by connecting the battery modules 10111 in series in the battery compartment 1011 may be electrically connected to the first electrode interface 10121121, and the second total electrode 101112 may be electrically connected to the second electrode interface 10121122. Therefore, a working state of the battery module 10111 in the battery compartment 1011 may be controlled by using the cluster control box 101211.

In this application, an arrangement manner of the DCDC 101213, the PCS 101212, and the cluster control box 101211 in the power compartment 1012 is not limited. For example, in the energy storage system shown in FIG. 3, the PCS 101212, the DCDC 101213, and the cluster control box 101211 may be disposed side by side in the height direction of the cabinet 1, and the DCDC 101213 may be located between the PCS 101212 and the cluster control box 101211. In addition, the junction box 1012123 of the PCS 101212 may be further used to avoid the DCDC 101213 and the cluster control box 101211 in physical space. During specific implementation, still refer to FIG. 7. The junction box 1012123 may be located at an end part of the PCS 101212, so that the junction box 1012123, the cluster control box 101211, and the DCDC 101213 are disposed in a staggered manner in an arrangement direction of the junction box 1012123, the cluster control box 101211, and the DCDC 101213, that is, a length of the PCS 101212 may be greater than a length of the cluster control box 101211 and a length of the DCDC 101213. In this way, when the PCS 101212, the DCDC 101213, and the cluster control box 101211 are all disposed in the power compartment 1012 in the cabinet body 101 shown in FIG. 3, the PCS 101212 may be prevented from blocking the cluster control box 101211 and the DCDC 101213, so that maintenance of the DCDC 101213 and the cluster control box 101211 can be facilitated.

It may be understood that, when the total voltage of the battery module 10111 in the battery compartment 1011 is higher than the rated designed voltage, the DCDC 101213 may not be configured in the power compartment 1012. In this case, the first output port 1012111 of the cluster control box 101211 may be electrically connected to the second input port 1012122 of the PCS 101212, and the arrangement manner of the cluster control box 101211 and the PCS 101212 and a connection between the cluster control box 101211 and the PCS 101212 and another structure both may be disposed with reference to FIG. 3 and FIG. 7. Details are not described herein.

In the energy storage system provided in this application, there is no need to separately dispose an accommodating apparatus for the PCS 101212. The PCS 101212, the DCDC 101213, and the cluster control box 101211 may all be disposed in the cabinet 1. This can help improve integration of the cabinet 1 and power density of the cabinet 1. In addition, because wiring between the PCS 101212, the DCDC 101213, and the cluster control box 101211 may be completed in the cabinet 1, the wiring between the PCS 101212, the DCDC 101213, and the cluster control box 101211 may be convenient. In addition, because the power modules 10121 in the power compartment 1012 are separately wired, a layout and wiring of the power modules 10121 are simple, thereby facilitating maintenance of the power modules 10121.

Because the power modules 10121 also generate a large amount of heat in a working process, to enable the power modules 10121 to have good working performance, in this application, the liquid cooling unit 2 may also be used to dissipate heat for the power modules 10121. During specific implementation, still refer to FIG. 6. The power module 10121 may include a second liquid inlet 10121a and a second liquid outlet 10121b, and the liquid cooling unit 2 may further include a second liquid outlet pipe 205 and a second liquid return pipe 206. The second liquid outlet pipe 205 may communicate with the second liquid inlet 10121a, and the second liquid return pipe 206 may communicate with the second liquid outlet 10121b. In this way, a coolant in the liquid cooling unit 2 may enter the power module 10121 from the second liquid outlet pipe 205 through the second liquid inlet 10121a, and the heated coolant in the power module 10121 may flow back to the liquid cooling unit 2 from the second liquid outlet 10121b through the second liquid return pipe 206, so that a second cooling circulation loop may be formed between the liquid cooling unit 2 and the power module 10121, to cool the power module 10121 by circulating the coolant in the second cooling circulation loop.

Because at least two power modules 10121 may be disposed in the power compartment 1012, to cool each power module 10121, in this application, a second liquid outlet branch 2051 may be disposed on the second liquid outlet pipe 205, and a second liquid return branch 2061 may be disposed on the second liquid return pipe 206. The second liquid outlet branch 2051 may be connected to the second liquid outlet pipe 205 by using a three-way valve, or the second liquid outlet branch 2051 is an elbow structure formed on the second liquid outlet pipe 205. The second liquid return branch 2061 may be connected to the second liquid return pipe 206 by using a three-way valve, or the second liquid return branch 2061 is an elbow structure formed on the second liquid return pipe 206.

It may be understood that a quantity of second liquid outlet branches 2051 and a quantity of second liquid return branches 2061 may be the same as a quantity of power modules 10121, so that the second liquid outlet branch 2051 is disposed in a one-to-one correspondence with the power module 10121, and the second liquid outlet branch 2051 communicates with the second liquid inlet 10121a of the power module 10121 that is correspondingly disposed. Similarly, the second liquid return branch 2061 is also disposed in a one-to-one correspondence with the power module 10121, and the second liquid return branch 2061 communicates with the second liquid outlet 10121b of the power module 10121 that is correspondingly disposed.

In addition, still refer to FIG. 6. A third stop valve 2052 may be disposed on the second liquid outlet pipe 205. When the liquid cooling unit 2 or the power module 10121 needs to be maintained or liquid needs to be replaced, the third stop valve 2052 may be closed, so that a liquid leakage phenomenon at the second liquid outlet pipe 205 can be avoided, to reduce a circuit fault caused by liquid leakage.

In this application, a specific type of the third stop valve 2052 is not limited. For example, the third stop valve 2052 may be a bidirectional stop valve. In this way, reliability of the third stop valve 2052 can be effectively improved. In addition, when the second liquid outlet branch 2051 is disposed on the second liquid outlet pipe 205, in a flow direction of the coolant, the third stop valve 2052 may be disposed on a part that is of the second liquid outlet pipe 205 and that is located before each third stop valve 2052. In this way, the coolant flowing through each second liquid outlet branch 2051 may be cut off by using one third stop valve 2052. This can help simplify the structure of the energy storage system.

Still refer to FIG. 6. A fourth stop valve 2062 may be disposed on the second liquid return pipe 206. When the liquid cooling unit 2 or the power module 10121 is maintained or liquid is replaced, the fourth stop valve 2062 may also be closed, so that a liquid leakage phenomenon at the second liquid return pipe 206 can be avoided, to reduce a circuit fault caused by liquid leakage.

In this application, a specific type of the fourth stop valve 2062 is not limited. For example, the fourth stop valve 2062 may be a bidirectional stop valve. In this way, reliability of the fourth stop valve 2062 can be effectively improved. It may be understood that, when the second liquid return branch 2061 is disposed on the second liquid return pipe 206, in a flow direction of the coolant, the fourth stop valve 2062 may be disposed on a part that is of the second liquid return pipe 206 and that is located before each fourth stop valve 2062. In this way, the coolant flowing out from each second liquid return branch 2061 may be cut off by using one fourth stop valve 2062. This can help simplify the structure of the energy storage system. In addition, when the third stop valve 2052 is disposed on the second liquid outlet pipe 205, and the fourth stop valve 2062 is disposed on the second liquid return pipe 206, a risk of liquid leakage in the entire second cooling circulation loop may be reduced, thereby reducing the circuit fault caused by liquid leakage.

It may be understood that, in this application, the liquid cooling unit 2 is disposed on the cabinet door 102, and the battery compartment 1011 and the power compartment 1012 are disposed on the cabinet body 101, so that a water and electricity separation design inside the cabinet 1 can be implemented, thereby improving use safety of the cabinet 1. In addition, the battery compartment 1011 and the power compartment 1012 may share one liquid cooling unit 2, to be specific, heat dissipation of the battery module 10111 in the battery compartment 1011 and the power module 10121 in the power compartment 1012 may be implemented by a same liquid cooling unit 2, so that the structure of the energy storage system may be simple. In some possible implementations, one liquid cooling unit 2 may be further disposed for each of the battery compartment 1011 and the power compartment 1012, so that the battery module 10111 in the battery compartment 1011 and the power module 10121 in the power compartment 1012 dissipate heat by the corresponding liquid cooling unit 2. In this case, each liquid cooling unit 2 may be disposed with reference to the liquid cooling unit 2 provided in the foregoing embodiment. Details are not described herein again.

In addition, in some possible embodiments of this application, when ambient temperatures of the battery module 10111 and the power module 10121 are low, that is, when heat dissipation requirements of the battery module 10111 and the power module 10121 are low, in a design of a communication valve in the liquid cooling unit 2, the first liquid outlet pipe 203 may communicate with the second liquid outlet pipe 205, and the first liquid return pipe 204 may communicate with the second liquid return pipe 206, so that a cooling loop of the battery module 10111 and a cooling loop of the power module 10121 may be connected in series, to form one cooling loop between the liquid cooling unit 2, the battery module 10111, and the power module 10121, thereby reducing heat dissipation costs.

In a working process, thermal runaway may occur in the battery module 10111 in the battery compartment 1011 due to machine, electricity, and heat abuse, disadvantages of the battery module 10111, and the like. In a thermal runaway process, a large amount of combustible gas is generated in the battery module 10111, and the combustible gas is with a high risk of burning and explosion. Shock waves and thermal radiation generate by burning and explosion and debris splashes caused by cabinet disintegration pose threats to safety of nearby people or objects. To reduce the risk of burning and explosion of the battery module 10111, it may be considered that the combustible gas generated when the thermal runaway occurs in the battery module 10111 is discharged to the outside of the cabinet 1, to reduce a concentration of the combustible gas in the cabinet 1.

During specific implementation, refer to FIG. 8. FIG. 8 is a sectional view of a top view of the energy storage system according to an embodiment of this application. The battery module 10111 may include a module housing 101113 and an air guide pipe 101114. The module housing 101113 has a mounting hole (not shown in FIG. 8), and the air guide pipe 101114 may communicate with the module housing 101113 through the mounting hole.

Still refer to FIG. 8. An explosion-proof valve 101115 may be further disposed on the battery module 10111, and the explosion-proof valve 101115 may be mounted in the mounting hole. In this case, the air guide pipe 101114 may communicate with the module housing 101113 by using the explosion-proof valve 101115. Because a technology of using the explosion-proof valve 101115 for the battery module 10111 is mature, details are not described herein. In this way, when the combustible gas makes the inside of the module housing 101113 reach specific pressure, the explosion-proof valve 101115 may be turned on, and the combustible gas may enter the air guide pipe 101114 by using the explosion-proof valve 101115.

In addition, a smoke exhaust pipe 103 is further disposed inside the cabinet 1. The smoke exhaust pipe 103 may be disposed inside the cabinet body 101, and the air guide pipe 101114 may communicate with the smoke exhaust pipe 103. In this case, the combustible gas may enter the smoke exhaust pipe 103 through the air guide pipe 101114.

To enable the combustible gas to be discharged to the outside of the cabinet 1 through the smoke exhaust pipe 103, in this embodiment of this application, the smoke exhaust pipe 103 may be provided with an exhaust hole, and a smoke exhaust vent may be provided on the cabinet 1, so that the exhaust hole communicates with the smoke exhaust vent. In this way, chimney effect may be formed in the smoke exhaust pipe 103, so that the combustible gas entering the smoke exhaust pipe 103 may be discharged to the outside of the cabinet 1 through the exhaust hole and the smoke exhaust vent.

In the foregoing embodiment of this application, the smoke exhaust pipe 103 may be of an independent structure. However, in some other possible embodiments, the smoke exhaust pipe 103 and the cabinet body 101 of the cabinet 1 may alternatively be disposed as an integrated structure, so that the structure of the energy storage system can be effectively simplified.

It may be understood that, when the smoke exhaust pipe 103 and the cabinet body 101 are of an integrated structure, the exhaust hole of the smoke exhaust pipe 103 may be used as a smoke exhaust vent of the cabinet body 101. In other words, in this solution, a communication operation between the exhaust hole and the smoke exhaust vent can be avoided. This can effectively simplify an assembly process of the energy storage system, and reduce a risk of flue gas spilling into the box.

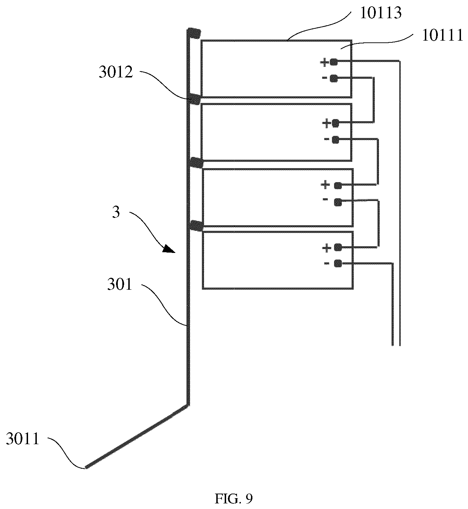

FIG. 9 is a diagram of another partial structure of the energy storage system according to an embodiment of this application. The energy storage system may further include a water fire extinguishing system 3. The water fire extinguishing system 3 includes a main fire extinguishing pipe 301, and the main fire extinguishing pipe 301 has a water inlet 3011. With reference to FIG. 1 and FIG. 9 together, in this application, the water inlet 3011 of the main fire extinguishing pipe 301 may be provided on the bottom wall of the cabinet 1, and the water inlet 3011 may extend to the outside of the cabinet 1, so that a connection between the water inlet 3011 and an external water source may be facilitated.

In addition, a nozzle 3012 may be further disposed on the main fire extinguishing pipe 301, and an outlet of the nozzle 3012 may be provided towards the battery module 10111. In this way, water entering the main fire extinguishing pipe 301 through the water inlet 3011 may be sprayed to the corresponding battery module 10111 through the nozzle 3012, to cool the module housing 101113 of the battery module 10111.

In this application, a specific quantity of nozzles 3012 is not limited. For example, the nozzle 3012 is disposed in a one-to-one correspondence with the battery module 10111. In this way, each battery module 10111 can be effectively cooled, to ensure performance reliability of the battery module 10111.

According to the energy storage system provided in the foregoing embodiment of this application, the liquid cooling unit 2 is disposed on the cabinet door 102, and the cabinet body 101 is divided into the battery compartment 1011 and the power compartment 1012, so that the battery module 10111 and the power modules 10121 are disposed in different compartments. This can help improve space utilization of the cabinet 1, thereby helping implement a miniaturization design of the energy storage system, and effectively improve mounting and maintenance efficiency of the energy storage system.

In addition, because the energy storage system is used, the PCS 101212, the DCDC 101213, and the cluster control box 101211 may all be disposed in the power compartment 1012, to avoid disposing the independent accommodating apparatus for the PCS 101212. Therefore, the structure of the energy storage system can be simplified, and the power modules 10121 of the energy storage system are connected conveniently.

In addition, in the energy storage system, the first cooling circulation loop is formed between the battery compartment 1011 and the liquid cooling unit 2, and the second cooling circulation loop is formed between the power compartment 1012 and the liquid cooling unit 2, so that independent heat management on the battery compartment 1011 and independent heat management on the power compartment 1012 can be implemented, and the independent heat management on the battery compartment 1011 and the independent heat management on the power compartment 1012 do not interfere with each other, thereby helping improve heat dissipation efficiency of the liquid cooling unit 2 for the battery compartment 1011 and the power compartment 1012.

To improve use security, the energy storage system further uses the foregoing plurality of security protection designs. In this way, when the thermal runaway occurs in the battery module 10111 and combustible gas is generated, the combustible gas may enter the smoke exhaust pipe 103 through the air guide pipe 101114, to be discharged to the outside of the cabinet 1 through the smoke exhaust pipe 103 in a directional manner. In addition, when the temperature of the battery module 10111 is excessively high, to avoid fire, the water fire extinguishing system 3 may be enabled, to spray water towards the module housing 101113 of the battery module 10111 through the nozzle 3012, to cool the module housing 101113. When the combustible gas overflows to the inside of the cabinet 1, the fan inside the cabinet 1 may be turned on, so that ventilation inside the cabinet 1 is implemented through the ventilation air inlet and the ventilation air outlet, to reduce the concentration of the combustible gas inside the cabinet 1. If there is a large amount of combustible gas that overflows to the cabinet 1, the concentration of the combustible gas cannot be significantly reduced through ventilation. In this case, the explosion relief window 1013 on the top of the cabinet 1 may be opened, to implement explosion relief for the cabinet 1. Based on this, the energy storage system provided in this application has high use security.

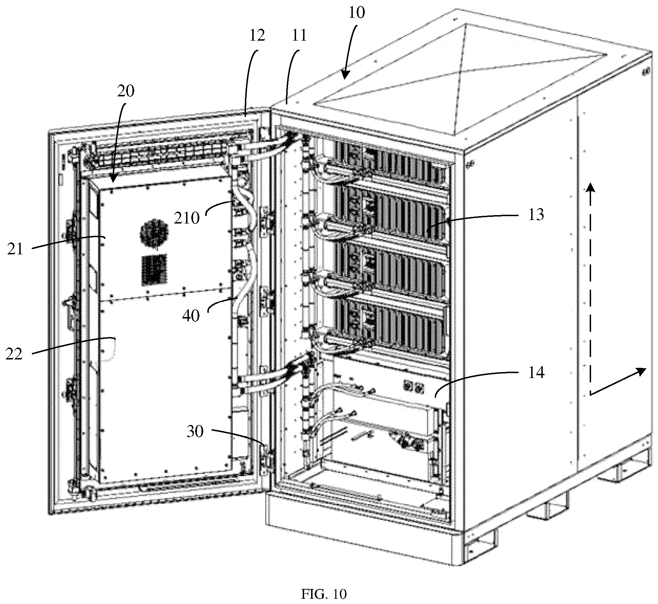

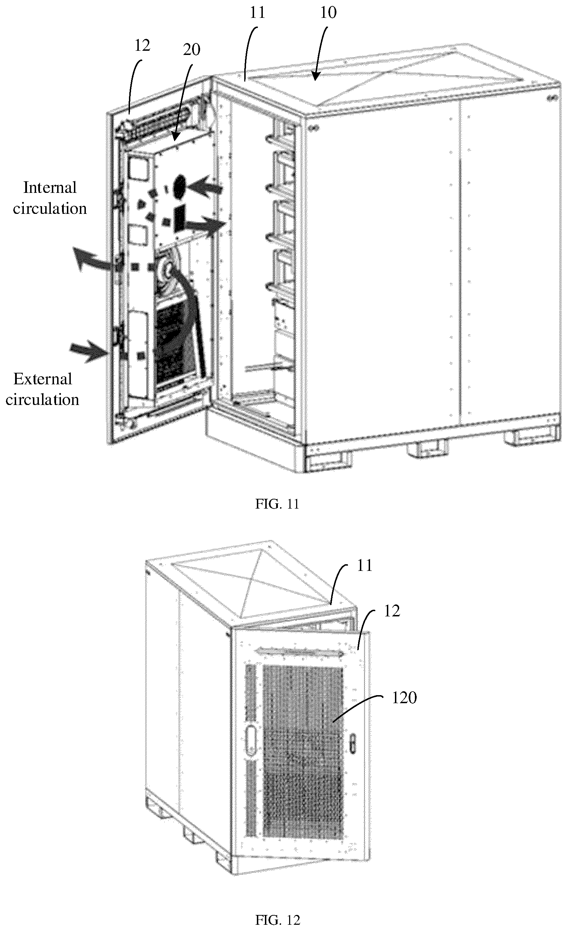

FIG. 10 is a diagram of a structure of an energy storage system according to an embodiment of this application. FIG. 10 may be a specific mechanical structural diagram of an implementation of the energy storage system provided in FIG. 3 and FIG. 6. FIG. 11 is a diagram of flow directions of gas in an internal circulation compartment and an external circulation compartment in the energy storage system according to an embodiment of this application. In FIG. 10, a direction of a dashed line arrow represents height directions of a cabinet body 11 and a cabinet door 12, and a direction of a solid line arrow represents a width direction of the cabinet body 11. Refer to FIG. 10 and FIG. 11. The energy storage system includes an energy storage cabinet 10 and a liquid cooling unit 20. The energy storage cabinet 10 is configured to accommodate the liquid cooling unit 20 and at least one of a battery pack 13 or a power converter 14. The energy storage cabinet 10 includes the cabinet body 11 and the cabinet door 12. The cabinet body 11 is configured to fasten the battery pack 13 or the power converter 14, and the cabinet door 12 is configured to cover the cabinet body 11, to seal the battery pack 13 or the power converter 14 in the cabinet body 11, and prevent the battery pack 13 or the power converter 14 from being damaged due to pollution caused by an external environment to the battery pack 13 or the power converter 14. When the liquid cooling unit 20 is disposed, the liquid cooling unit is fastened on a side that is of the cabinet door 12 and that faces the battery pack 13 or the power converter 14. In this way, independent space for mounting the liquid cooling unit 20 does not need to be provided in the cabinet body 11, so that the liquid cooling unit 20 occupies small space of the cabinet body 11, to increase a capacity of the energy storage cabinet 10.

It should be noted that the cabinet body 11 accommodates the battery pack 13 or the power converter 14, or the cabinet body 11 accommodates the battery pack 13 and the power converter 14. The power converter 14 shown in FIG. 10 may be specifically a power conversion system (power conversion system, PCS), and the battery pack may also be referred to as a battery module. The following uses an example in which the cabinet body includes the battery pack 13 and the power converter for description.

Still refer to FIG. 10 and FIG. 11. Internal circulation in FIG. 11 means a process in which gas in the cabinet body 11 flows into an internal circulation compartment 21 and flows out of the internal circulation compartment 21. External circulation means a process in which gas outside the energy storage cabinet 10 flows into an external circulation compartment 22 and flows out of the external circulation compartment 22. In the height direction of the cabinet door 12, the liquid cooling unit 20 includes the internal circulation compartment 21 and the external circulation compartment 22, and the internal circulation compartment 21 is stacked on the external circulation compartment 22. The internal circulation compartment 21 and the external circulation compartment 22 are separated from each other. The internal circulation compartment 21 communicates with the cabinet body 11, so that the gas in the cabinet body 11 enters the internal circulation compartment 21. The internal circulation compartment 21 dehumidifies the gas that is in the cabinet body 11 and that enters the internal circulation compartment 21. The external circulation compartment 22 communicates with the outside of the energy storage cabinet 10, so that the external gas exchanges heat with a component in the external circulation compartment 22. In addition, the internal circulation compartment 21 and the external circulation compartment 22 are separated from each other, so that components in the liquid cooling unit 20 are disposed in different regions for ease of maintenance. In addition, external gas is prevented from entering the inside of the cabinet body 11, to improve working stability of the battery pack 13 and the power converter 14 in the cabinet body 11.

Still refer to FIG. 10 and FIG. 11. The cabinet body 11 is connected to the cabinet door 12 in the width direction of the cabinet body 11 by using a hinge structure 30, the internal circulation compartment 21 includes a liquid cooling terminal interface group 210, the liquid cooling terminal interface group 210 is arranged on a side that is of the internal circulation compartment 21 and that faces the hinge structure 30, the liquid cooling terminal interface group 210 is configured to communicate with at least one liquid cooling pipe group 40, and the at least one liquid cooling pipe group 40 is configured to dissipate heat for the battery pack 13 and the power converter 14. The liquid cooling pipe group 40 is connected to the liquid cooling terminal interface group 210 in a quick-plug manner, so that the battery pack 13 and the power converter 14 are conveniently connected to the liquid cooling unit 20, and convenience of connecting the battery pack 13 and the power converter 14 to the liquid cooling unit 20 is improved.

Refer to FIG. 10 and FIG. 6. The liquid cooling pipe group 40 in FIG. 10 may include the first liquid outlet pipe 203, the first liquid return pipe 204, the second liquid outlet pipe 205, and the second liquid return pipe 206 mentioned in FIG. 6. The liquid cooling terminal interface group 210 is configured to communicate with the first liquid outlet pipe 203, the first liquid return pipe 204, the second liquid outlet pipe, and the second liquid return pipe. FIG. 12 is a diagram of a structure of another energy storage system according to an embodiment of this application. Refer to FIG. 10 and FIG. 12. To facilitate mounting of the liquid cooling unit 20 on the cabinet door 12, a side that is of the cabinet door 12 and that is away from the cabinet body 11 is provided with a mounting opening (not shown in the figure), and the liquid cooling unit 20 is mounted on the mounting opening. To prevent an impurity from entering the external circulation compartment, a protective net 120 is mounted on the mounting opening.

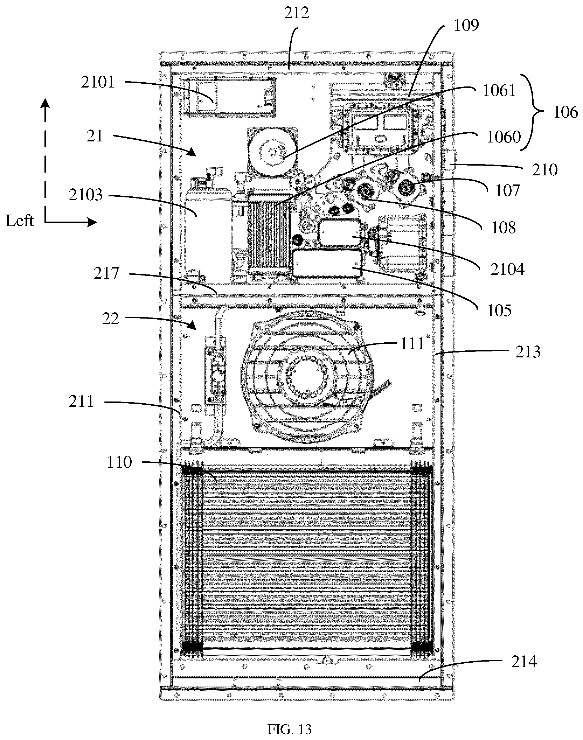

FIG. 13 is a diagram of a structure of a liquid cooling unit according to an embodiment of this application. Refer to FIG. 13. The internal circulation compartment 21 is further configured to accommodate an electronic control apparatus 2101, a valve body assembly, a compressor 2103, a condensation plate heat exchanger 2104, an evaporation plate heat exchanger 105, a dehumidification module 106, a first water pump 107, and a second water pump 108, the electronic control apparatus 2101 is electrically connected to the compressor 2103, the valve body assembly, the dehumidification module 106, the first water pump 107, and the second water pump 108, the valve body assembly 2102 separately communicates with the liquid cooling terminal interface group 210, the compressor 2103, the evaporation plate heat exchanger 105, the condensation plate heat exchanger 2104, and the dehumidification module 106, and the condensation plate heat exchanger 2104 provides a cold source for the dehumidification module 106. In this manner, the dehumidification module 106 dehumidifies gas in the cabinet body, the condensation plate heat exchanger 2104 provides the cold source for the dehumidification module 106, and an independent cold source for serving the dehumidification module 106 is not needed. This can simplify a structure of the liquid cooling unit, and can further reduce costs of the liquid cooling unit.

The dehumidification module 106 includes a dehumidification evaporator 1060 and a dehumidification fan 1061.

In FIG. 13, a direction of a dashed line arrow represents the height direction of the cabinet door, and a direction of a solid line arrow represents the width direction of the cabinet door. Still refer to FIG. 1. The compressor 2103 and the electronic control apparatus 2101 are disposed at an interval in the height direction of the cabinet door, the evaporation plate heat exchanger 105 and the condensation plate heat exchanger 2104 are disposed at an interval, the first water pump 107 and the second water pump 108 are located between the condensation plate heat exchanger 2104 and a top of the internal circulation compartment, the compressor 2103 and the condensation plate heat exchanger 2104 are disposed at an interval in the width direction of the cabinet door, the dehumidification module 106 is disposed between the compressor 2103 and the condensation plate heat exchanger 2104, the first water pump 107 and the second water pump 108 are disposed at an interval, and the valve body assembly and the condensation plate heat exchanger 2104 are disposed at an interval in a direction perpendicular to the height direction of the cabinet body and the width direction of the cabinet body; and the compressor 2103 is disposed at a bottom of the internal circulation compartment, the electronic control apparatus 2101 is disposed at the top of the internal circulation compartment, and the compressor 2103 and the electronic control apparatus 2101 are located on a left side of the internal circulation compartment in the width direction of the cabinet door. This disposition manner can enable disposition of the components in the internal circulation compartment more compact.

Still refer to FIG. 13. The internal circulation compartment 21 further accommodates an integrated plate 109, the valve body assembly is disposed inside the integrated plate 109, and the first water pump 107, the second water pump 108, the evaporation plate heat exchanger 105, and the condensation plate heat exchanger 104 are all disposed on the integrated plate 109. In this way, the components are disposed in the internal circulation compartment more easily. In addition, the dehumidification module 106 may also be integrated on the integrated plate 109, to be specific, the dehumidification evaporator 1060 and the dehumidification fan 1061 are also disposed on the integrated plate 109.

Still refer to FIG. 13. The external circulation compartment 22 is configured to accommodate an outdoor heat exchanger 110 and at least one heat exchange fan 111, and the heat exchange fan 111 is disposed above the outdoor heat exchanger in the height direction of the cabinet door. The outdoor heat exchanger 110 is configured to exchange heat with the outside of the energy storage cabinet. Gas outside the energy storage cabinet enters the external circulation compartment 22 through the outdoor heat exchanger 110, and flows out of the external circulation compartment through the heat exchange fan 111. The outdoor heat exchanger 110 communicates with the valve body assembly. A quantity of heat exchange fans 111 is set based on an actual requirement.

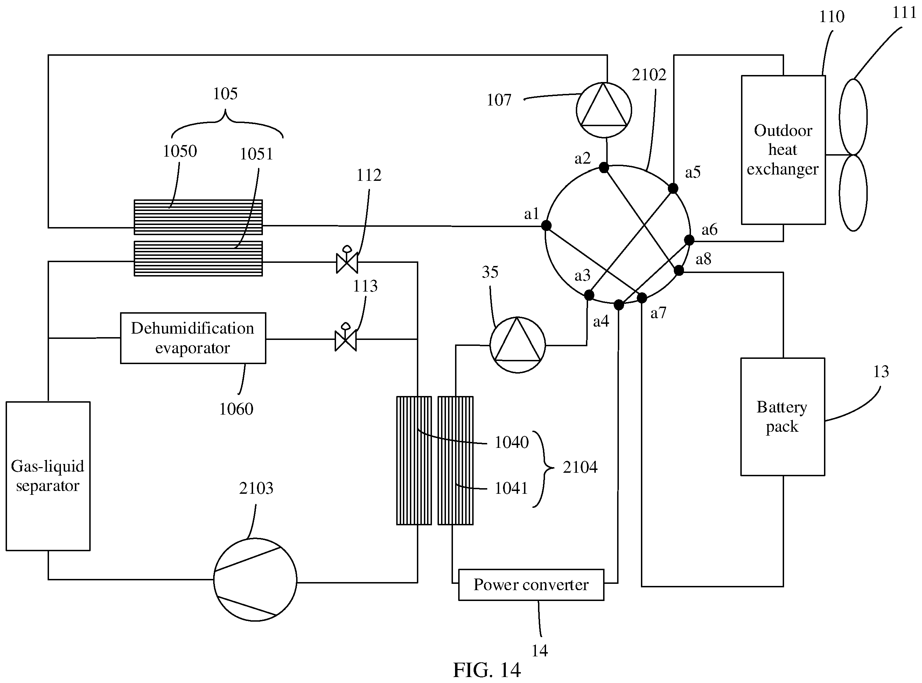

FIG. 14 is a diagram of a structure of performing heat exchange between a liquid cooling unit and a battery pack and a power converter in an energy storage system according to an embodiment of this application. The evaporation plate heat exchanger 105 includes a first heat exchange part 1050 and a second heat exchange part 1051, and the condensation plate heat exchanger 104 includes a third heat exchange part 1040 and a fourth heat exchange part 1041. A first end of the first water pump 107 communicates with a second port a2 of the valve body assembly 2102, a second end of the first water pump 107 communicates with a second end of the first heat exchange part 1050, a first end of the first heat exchange part 1050 communicates with a first end a1 of the valve body assembly 2102, and the second heat exchange part 1051, the third heat exchange part 1040, and the compressor 2103 are sequentially connected in series to form a closed loop. A first end of the second water pump 108 communicates with a third end a3 of the valve body assembly 2102, a second end of the second water pump 108 communicates with a first end of the fourth heat exchange part 1041, a second end of the fourth heat exchange part 1041 communicates with a first end of the power converter 14, and a second end of the power converter 14 communicates with a fourth end a4 of the valve body assembly 2102. A first end of the outdoor heat exchanger 110 communicates with a fifth end a5 of the valve body assembly 2102, a second end of the outdoor heat exchanger 110 communicates with a sixth end a6 of the valve body assembly 2102, and a seventh end a7 and an eighth end a8 of the valve body assembly 2102 communicate with the battery pack 13.

Still refer to FIG. 14. The foregoing valve body assembly 2102 has eight ports, that is, the valve body assembly 2102 is an eight-way valve. When the battery pack 13 and the power converter 14 need to be cooled, the electronic control apparatus controls, in the valve body assembly 2102, the first end a1 to communicate with the seventh end a7, the second end a2 to communicate with the eighth end a8, the third end a3 to communicate with the fifth end a5, and the fourth end a4 to communicate with the sixth end a6. The electronic control apparatus further controls the compressor 2103 to work. High-temperature and high-pressure gas is discharged from an exhaust vent of the compressor 2103, and enters the third heat exchange part 1040. The high-temperature and high-pressure gas exchanges heat with the fourth heat exchange part 1041 through the third heat exchange part 1040 to become a liquid refrigerant. In this process, a temperature of a refrigerant in the fourth heat exchange part 1041 increases. The liquid refrigerant formed by passing through the third heat exchange part 1040 enters the second heat exchange part 1051, absorbs heat in the first heat exchange part 1050 and vaporizes through the second heat exchange part 1051. In this process, a temperature of a refrigerant in the first heat exchange part 1050 decreases, a cooled refrigerant in the first heat exchange part 1050 flows to a liquid cooling end 130 through the valve body assembly 2102, and the refrigerant flows to the battery pack 13 to take away heat generated by the battery pack 13, thereby avoiding an excessively high temperature in the energy storage cabinet. In addition, when a refrigerant with a rising temperature in the fourth heat exchange part 1041 passes through the power converter 14, the power converter 14 is cooled. The refrigerant passing through the power converter 14 enters the outdoor heat exchanger 110 for further cooling through the valve body assembly 2102, and flows back to the fourth heat exchange part 1041 through the valve body assembly 2102 under driving of the second water pump 108, to continue to absorb heat of the third heat exchange part 1040.

In the foregoing embodiment, the liquid cooling unit further includes a first valve body 112 and a second valve body 113. The first valve body 112 is disposed between the second heat exchange part 1051 and the third heat exchange part 1040. A dehumidification apparatus includes the dehumidification evaporator 1060 and the dehumidification fan. Two ends of the dehumidification evaporator 1060 respectively communicate with the third heat exchange part 1040 and the compressor 2103, that is, the dehumidification evaporator 1060 and the second heat exchange part 1051 are connected in parallel, and the second valve body 113 is disposed between the dehumidification evaporator 1060 and the third heat exchange part 1040. When dehumidification needs to be performed on the air in the energy storage cabinet, and the electronic control apparatus controls the compressor 2103 to work and the second valve body 113 to be in an open state, the dehumidification fan sucks the gas in the energy storage cabinet into the internal circulation compartment through an air inlet. When the dehumidification evaporator 1060 is specifically disposed, the dehumidification evaporator 1060 is disposed on a side close to the dehumidification fan, so that most gas entering the internal circulation compartment needs to pass through the dehumidification evaporator 1060. The dehumidification evaporator 1060 communicates with a third heat exchange pipe group 370, and the liquefied low-temperature refrigerant in the third heat exchange part 1040 passes through the dehumidification evaporator 1060. In this way, the gas passing through the dehumidification evaporator 1060 is cooled. When the gas reaches a dew point temperature, water in the gas may be precipitated into liquid water and flow into a condensate water pan of the liquid cooling unit, and then exhausted back to the energy storage cabinet, to achieve dehumidification.

It should be noted that, when dehumidification needs to be performed on the air in the energy storage cabinet, it is determined, based on humidity in the energy storage cabinet, to open or close the first valve body 112. Similarly, when the battery pack 13 and the power converter 14 are cooled, it is determined, based on a temperature of the gas in the energy storage cabinet, to open or close the second valve body 113.

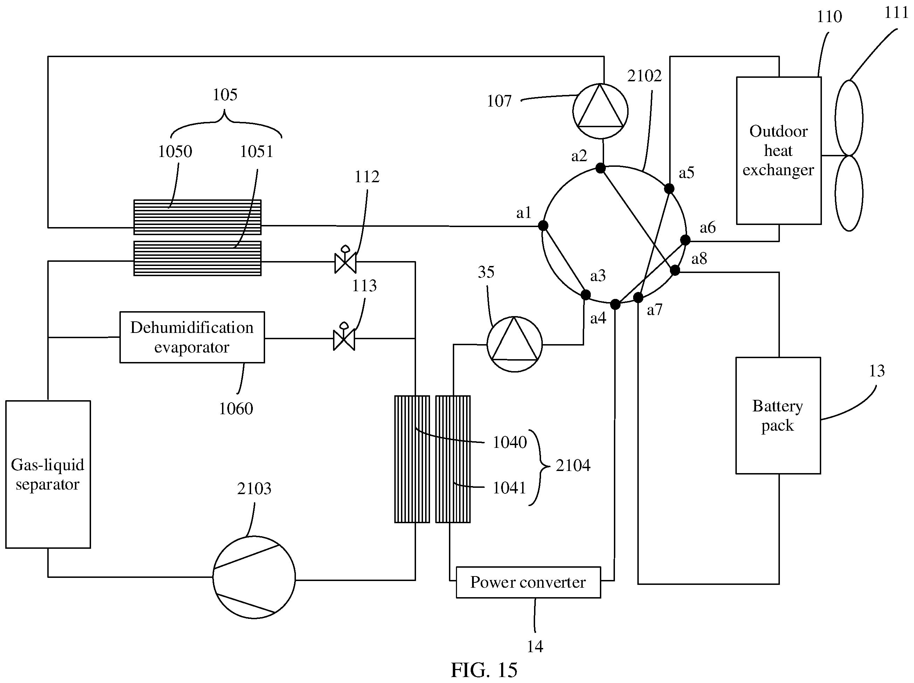

FIG. 15 is a diagram of another structure of a liquid cooling unit during working according to an embodiment of this application. Refer to FIG. 15. When the battery pack 13 and the power converter 14 need to be cooled, the electronic control apparatus further controls, in the valve body assembly 2102, a first end a1 to communicate with a third end a3, a second end a2 to communicate with an eighth end a8, a fourth end a4 to communicate with a sixth end a6, and a fifth end a5 to communicate with a seventh end a7. In this case, the electronic control apparatus further controls the compressor 2103 not to work, and a refrigerant completes heat exchange with the gas outside the energy storage cabinet through the outdoor heat exchanger 110, so that a temperature of the refrigerant decreases. A low-temperature refrigerant enters a liquid cooling end 130 through the fifth end a5 and the seventh end a7 of the valve body assembly 2102, to cool an energy storage battery. After the refrigerant passing through the liquid cooling end 130 passes through the eighth end a8 and the second end a2 of the valve body assembly 2102, the first water pump 107 and the first heat exchange part 1050, the refrigerant passes through the first end a1 and the third end a3 of the valve body assembly 2102, and flows through the power converter 14 through the fourth heat exchange part 1041 under driving of the second water pump 108, to cool the power converter 14. The refrigerant passing through the power converter 14 flows back to the outdoor heat exchanger 110 through the fourth end a4 and the sixth end a6 of the valve body assembly 2102, and exchanges heat with the gas outside the energy storage cabinet through the outdoor heat exchanger 110. In this process, because the compressor 2103 does not work, the first heat exchange part 1050 does not exchange heat with the second heat exchange part 1051, and the fourth heat exchange part 1041 does not exchange heat with the third heat exchange part 1040.

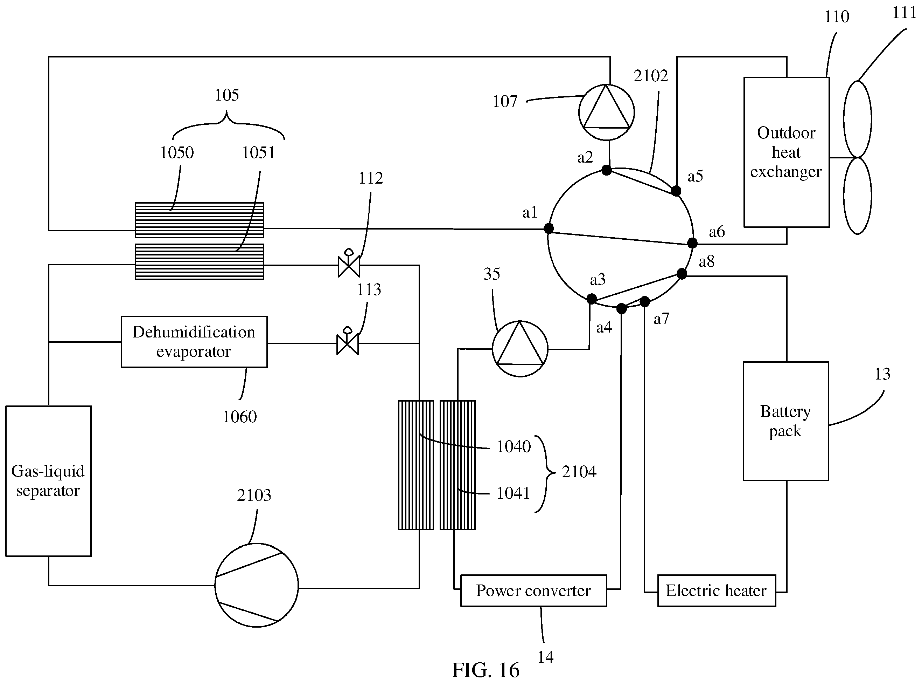

FIG. 16 is a diagram of another structure of a liquid cooling unit during working according to an embodiment of this application. Refer to FIG. 16. In a specific implementation process, the energy storage cabinet can also be in a low-temperature environment, and the battery pack 13 and the power converter 14 need to be heated. In this case, the electronic control apparatus controls, in the valve body assembly 2102, a first end a1 to communicate with a sixth end a6, a second end a2 to communicate with a fifth end a5, a third end a3 to communicate with an eighth end a8, and a fourth end a4 to communicate with a seventh end a7. In addition, an electric heater is further disposed in the energy storage cabinet. The electric heater is connected between the seventh end a7 of the valve body assembly 2102 and a liquid cooling end 130. The electric heater heats a refrigerant that enters the electric heater through the seventh end a7 of the valve body assembly 2102. A heated refrigerant flows into the liquid cooling end 130 to heat an energy storage battery, and then flows through the second water pump 108 through the eighth end a8 of the valve body assembly 2102 and the third end a3 of the valve body assembly 2102. After the refrigerant passing through the second water pump 108 enters the fourth heat exchange part 1041, the refrigerant flows through the power converter 14, to heat the power converter 14, and the refrigerant passing through the power converter 14 flows back to the electric heater through the fourth end a4 and the seventh end a7 of the valve body assembly. In this process, heat exchange is not performed between the fourth heat exchange part 1041 and the third heat exchange part 1040, and the compressor 2103 does not work.

Still refer to FIG. 16. When the energy storage battery and the power converter 14 are heated, the electric heater does not work, and the compressor 2103 is controlled to work. High-temperature and high-pressure gas is discharged from an exhaust vent of the compressor 2103, and enters the third heat exchange part 1040. The high-temperature and high-pressure gas exchanges heat with a fourth heat exchange pipe group 371 through the third heat exchange part 1040 to become a liquid refrigerant. In this process, a temperature of a refrigerant in the fourth heat exchange part 1041 can increase, and a refrigerant with a rising temperature flows through the power converter 14, to heat the power converter 14. The refrigerant passing through the power converter 14 enters the liquid cooling end 130 through the fourth end a4 and the seventh end a7 of the valve body assembly 2102, to heat the liquid cooling end 130. The refrigerant passing through the liquid cooling end 130 flows back to the fourth heat exchange part 1041 through the eighth end a8 and the third end a3 of the valve body assembly 2102 under an action of the second water pump 108. The liquid refrigerant formed by passing through a third heat exchange pipe group 370 enters the second heat exchange part 1051, absorbs heat in the first heat exchange part 1050 and vaporizes through the second heat exchange part 1051. In this process, a temperature of a refrigerant in the first heat exchange part 1050 decreases, and a cooled refrigerant in the first heat exchange part 1050 flows to an outdoor heat exchanger 110 through the first water pump 107 and the second end a2 and the fifth end a5 of the valve body assembly 2102, and exchanges heat with the gas outside the energy storage cabinet through the outdoor heat exchanger 110, to cool the refrigerant. A cooled refrigerant flows back to the first heat exchange part 1050 through the sixth end a6 and the first end a1 of the valve body assembly 2102.

In the foregoing embodiment, the liquid cooling unit further includes a gas-liquid separator. The gas-liquid separator separates the refrigerant that passes through the second heat exchange part 1051 into a gas refrigerant and a liquid refrigerant, and the gas refrigerant enters the compressor 2103.

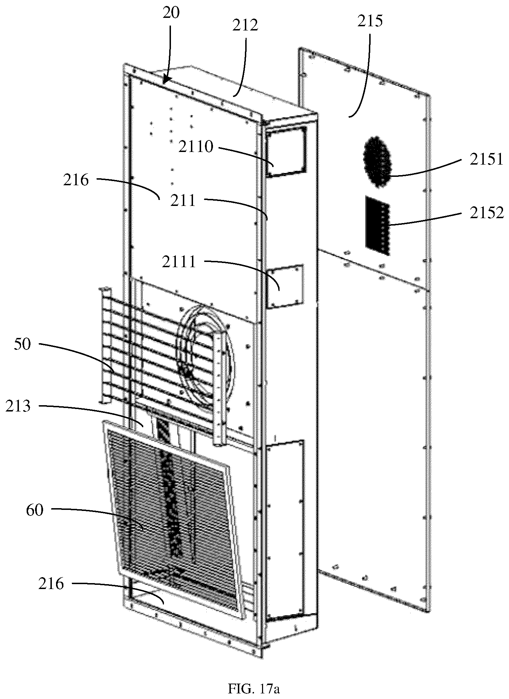

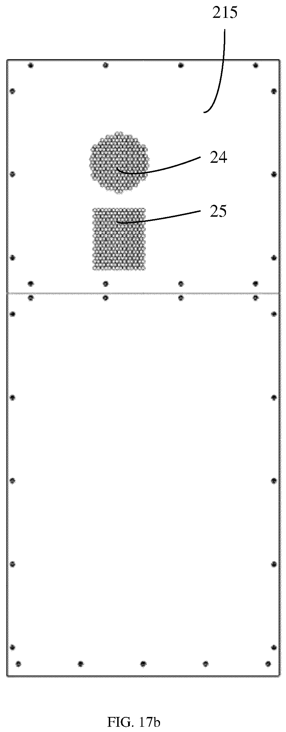

FIG. 17a is a diagram of another structure of a liquid cooling unit according to an embodiment of this application. FIG. 17b is a diagram of a structure of a first cover plate in FIG. 17a. Refer to FIG. 13, FIG. 17a, and FIG. 17b. The liquid cooling unit 20 includes a main frame, a first cover plate 215, a second cover plate 216, and a partition plate 217, and the main frame is mounted on the cabinet door; and the main frame includes a first side plate 211, a second side plate 212, a third side plate 213, and a fourth side plate 214 that are sequentially connected head to tail, one end of the partition plate 217 is connected to the first side plate 211 and the other end of the partition plate 217 is connected to the third side plate 213 in the width direction of the cabinet door, the partition plate 217 is disposed in parallel with the second side plate 212 and the fourth side plate 214, the first cover plate 215 is located on a side that is of the main frame and that faces the cabinet body, and the first cover plate 215 covers the side that is of the main frame and that faces the cabinet body. The second cover plate 216 is located on a side that is of the main frame and that faces the cabinet door, and the second cover plate 216 covers a part between the partition plate 217 and the second side plate 212. Specifically, the compressor 2103 is mounted on a side that is of the partition plate 217 and that faces the second side plate 212, and the compressor 2103 is close to the first side plate 211. The electronic control apparatus 2101 is mounted on a side that is of the second side plate 212 and that faces the first side plate 211, and the electronic control apparatus 2101 is close to the first side plate 211. The integrated plate 109 is connected to the partition plate 217 and the third side plate 213. The dehumidification module 106 is disposed between the integrated plate 109 and the compressor 2103, the evaporation plate heat exchanger 105 and the condensation plate heat exchanger 104 are disposed at an interval in the height direction of the cabinet door, and the first water pump 107 and the second water pump 108 are disposed at an interval in the width direction of the cabinet door. In this disposition manner, integration of the component in the internal circulation compartment 21 is higher. It should be noted that, in the width direction of the cabinet door, the first side plate 211 is disposed on a left side, and the foregoing liquid cooling terminal interface group 210 is disposed on the third side plate 213. In addition, the partition plate 217, the first cover plate 215, the first side plate 211, the third side plate 213, and the fourth side plate 214 form the external circulation compartment. The partition plate 217, the first cover plate 215, the second cover plate 216, the first side plate 211, the second side plate 212, and the third side plate 213 form the internal circulation compartment.

The first cover plate 215 is provided with an air inlet 2151 and an air outlet 2152. The air inlet 2151 corresponds to the dehumidification fan, and the air outlet 2152 corresponds to the dehumidification evaporator. The dehumidification fan enables the gas in the cabinet body to quickly enter the internal circulation compartment, and gas exhausted through the air outlet is dehumidified by the dehumidification evaporator.

Still refer to FIG. 17a. The first side plate 211 is provided with a first opening and a second opening; the first opening and the second opening are located between the partition plate 217 and the second side plate 212; the first opening is provided on a side that is of the first side plate 211 and that is close to the second side plate 212, so that the first opening corresponds to the electronic control apparatus 2101; and the second opening is provided on a side that is of the first side plate 211 and that is close to the partition plate 217, so that the second opening corresponds to the compressor 2103. It should be noted that the first opening is provided with an openable and closable window, to form a first maintenance window 2110, and the second opening is also provided with an openable and closable window, to form a second maintenance window 2111. The first maintenance window 2110 and the second maintenance window 2111 are provided, to facilitate maintenance of the electronic control apparatus 2101 and the compressor 2103.

Still refer to FIG. 17a. The liquid cooling unit 20 further includes a filter screen 60 and an air guide shutter 50. Both the filter screen 60 and the air guide shutter 50 are detachably connected to the first side plate and the third side plate, to facilitate maintenance of the filter screen 60 and the air guide shutter 50. The filter screen corresponds to the outdoor heat exchanger, to prevent a large-granularity impurity from entering the outdoor heat exchanger. The air guide shutter 50 corresponds to the at least one heat exchange fan, to avoid discharged gas flowing back, which causes low heat exchange efficiency of the outdoor heat exchanger.

It is clearly that a person skilled in the art can make various modifications and variations to this application without departing from the spirit and scope of this application. In this way, this application is intended to cover these modifications and variations of this application provided that they fall within the scope of protection defined by the following claims and their equivalent technologies.

## Claims

1. An energy storage system, comprising a cabinet and a liquid cooling unit, wherein the cabinet comprises a cabinet door and a cabinet body, and the cabinet door is in a hinged connection to the cabinet body;
the cabinet body comprises a battery compartment, a battery module is disposed in the battery compartment, and the battery module comprises a first liquid inlet and a first liquid outlet; and
the liquid cooling unit is disposed on a side that is of the cabinet door and that faces the cabinet body, the liquid cooling unit comprises a first liquid outlet pipe and a first liquid return pipe, the first liquid outlet pipe communicates with the first liquid inlet, and the first liquid return pipe communicates with the first liquid outlet.

2. The energy storage system according to claim 1, wherein the cabinet body further comprises a power compartment, a power module is disposed in the power compartment, and the power module comprises a second liquid inlet and a second liquid outlet; and
the liquid cooling unit further comprises a second liquid outlet pipe and a second liquid return pipe, the second liquid outlet pipe communicates with the second liquid inlet, and the second liquid return pipe communicates with the second liquid outlet.

3. The energy storage system according to claim 1 or 2, wherein at least two battery modules are disposed in the battery compartment, first liquid outlet branches are disposed on the first liquid outlet pipe, and a quantity of first liquid outlet branches is the same as a quantity of battery modules; and first liquid return branches are disposed on the first liquid return pipe, and a quantity of first liquid return branches is the same as the quantity of battery modules; and
each first liquid outlet branch communicates with the first liquid inlet of the battery module that is correspondingly disposed, and each first liquid return branch communicates with the first liquid outlet of the battery module that is correspondingly disposed.

4. The energy storage system according to any one of claims 1 to 3, wherein at least two power modules are disposed in the power compartment, second liquid outlet branches are disposed on the second liquid outlet pipe, and a quantity of second liquid outlet branches is the same as a quantity of power modules; and second liquid return branches are disposed on the second liquid return pipe, and a quantity of second liquid return branches is the same as a quantity of power modules; and
each second liquid outlet branch communicates with the second liquid inlet of the power module that is correspondingly disposed, and each second liquid return branch communicates with the second liquid outlet of the power module that is correspondingly disposed.

5. The energy storage system according to any one of claims 1 to 4, wherein a first stop valve is disposed on the first liquid outlet pipe, a second stop valve is disposed on the first liquid return pipe, a third stop valve is disposed on the second liquid outlet pipe, and a fourth stop valve is disposed on the second liquid return pipe.

6. The energy storage system according to any one of claims 2 to 5, wherein the battery compartment and the power compartment are disposed side by side in a height direction of the cabinet body.

7. The energy storage system according to claim 6, wherein the at least two power modules are disposed in the power compartment, the at least two power modules comprise cluster control boxes and power conversion systems, the cluster control box has a first output port and a first input port, the power conversion system has a second output port and a second input port, and the first output port is electrically connected to the second input port.

8. The energy storage system according to claim 7, wherein the first input port comprises a first electrode interface and a second electrode interface, the at least two battery modules are disposed in the battery compartment, the at least two battery modules are connected in series to form a first total electrode and a second total electrode, the first total electrode is electrically connected to the first electrode interface, and the second total electrode is electrically connected to the second electrode interface.

9. The energy storage system according to claim 7 or 8, wherein the power module further comprises a direct current converter, the direct current converter comprises a third input port and a third output port, the first output port is electrically connected to the third input port, and the third output port is electrically connected to the second input port.

10. The energy storage system according to any one of claims 7 to 9, wherein a junction box is disposed on the power conversion system, the junction box is located at one end of the power conversion system, the power conversion system is located above the cluster control box in the height direction of the cabinet body, a length of the power conversion system is greater than a length of the cluster control box in a length direction of the cabinet body, and the junction box and the cluster control box are disposed in a staggered manner.

11. The energy storage system according to any one of claims 7 to 9, wherein a junction box is disposed on the power conversion system, the junction box is located at one end of the power conversion system, the direct current converter is located between the power conversion system and the cluster control box in the height direction of the cabinet body, a length of the power conversion system, in a length direction of the cabinet body, is greater than a length of the cluster control box, and is also greater than a length of the direct current converter, and the junction box, the direct current converter, and the cluster control box are disposed in a staggered manner.

12. The energy storage system according to any one of claims 1 to 11, wherein the battery module comprises a module housing and an air guide pipe, an explosion-proof valve is disposed on the module housing, and the air guide pipe communicates with the module housing by using the explosion-proof valve; and
a smoke exhaust pipe and a smoke exhaust vent are further disposed on the cabinet, the smoke exhaust pipe has an exhaust hole, the air guide pipe communicates with the smoke exhaust pipe, and the exhaust hole communicates with the smoke exhaust vent.

13. The energy storage system according to any one of claims 1 to 12, wherein the cabinet door is further provided with a ventilation air outlet area and a ventilation air inlet area, the ventilation air outlet area and the ventilation air inlet area are provided at an interval, the ventilation air outlet area has an air outlet hole, the air outlet hole passes through the cabinet door in a direction from the outside of the cabinet body to the inside of the cabinet body, the ventilation air inlet area has an air inlet hole, and the air inlet hole passes through the cabinet door in the direction from the outside of the cabinet body to the inside of the cabinet body.

14. The energy storage system according to any one of claims 1 to 13, wherein the cabinet door is provided with a cooling area, the cooling area has a through hole, the through hole passes through the cabinet door in the direction from the outside of the cabinet body to the inside of the cabinet body, and a projection of the liquid cooling unit on the cabinet door overlaps at least a part of the cooling area.

15. The energy storage system according to claim 14, wherein the liquid cooling unit further comprises a unit housing, a sealing ring is further disposed between the unit housing and the cabinet door, the sealing ring is disposed around the cooling area, and the unit housing presses the sealing ring towards the cabinet door.

16. The energy storage system according to claim 15, wherein a flange edge is disposed on the unit housing, the flange edge is attached to the cabinet door, and the flange edge is fastened to the cabinet door.

17. The energy storage system according to any one of claims 1 to 16, wherein the liquid cooling unit comprises an internal circulation compartment and an external circulation compartment, the internal circulation compartment is stacked on the external circulation compartment in a height direction of the cabinet door, the internal circulation compartment is separated from the external circulation compartment, the internal circulation compartment communicates with the cabinet body, and the external circulation compartment communicates with the outside of the energy storage cabinet.

18. The energy storage system according to any one of claims 1 to 17, wherein the cabinet door is connected to the cabinet body in a width direction of the cabinet door by using a hinge structure, the internal circulation compartment comprises a liquid cooling terminal interface group, the liquid cooling terminal interface group is arranged on a side that is of the internal circulation compartment and that faces the hinge structure, and the liquid cooling terminal interface group is configured to communicate with the first liquid outlet pipe and the first liquid return pipe.

19. The energy storage system according to any one of claims 2 to 17, wherein the cabinet door is connected to the cabinet body in a width direction of the cabinet door by using a hinge structure, the internal circulation compartment comprises a liquid cooling terminal interface group, the liquid cooling terminal interface group is arranged on a side that is of the internal circulation compartment and that faces the hinge structure, and the liquid cooling terminal interface group is configured to communicate with the first liquid outlet pipe, the first liquid return pipe, the second liquid outlet pipe, and the second liquid return pipe.

20. The energy storage system according to any one of claims 17 to 19, whereinthe internal circulation compartment is configured to accommodate an electronic control apparatus, a valve body assembly, a compressor, a condensation plate heat exchanger, and a dehumidification module, the electronic control apparatus is electrically connected to the compressor, the valve body assembly, and the dehumidification module, the valve body assembly separately communicates with the liquid cooling terminal interface group, the compressor, the condensation plate heat exchanger, and the dehumidification module, and the condensation plate heat exchanger is configured to provide a cold source for the dehumidification module.

21. The energy storage system according to claim 20, wherein the compressor and the electronic control apparatus are disposed at an interval in the height direction of the cabinet door, the compressor and the condensation plate heat exchanger are disposed at an interval in the width direction of the cabinet door, the dehumidification module is located between the compressor and the condensation plate heat exchanger, and the valve body assembly and the condensation plate heat exchanger are disposed at an interval in a direction perpendicular to the height direction of the cabinet body and a width direction of the cabinet body; and
the compressor is disposed at a bottom of the internal circulation compartment, the electronic control apparatus is disposed at a top of the internal circulation compartment, and the compressor and the electronic control apparatus are located on a left side of the internal circulation compartment in the width direction of the cabinet door.

22. The energy storage system according to claim 21, wherein the internal circulation compartment comprises a first maintenance window and a second maintenance window, the first maintenance window and the second maintenance window are provided at an interval in the height direction of the cabinet door, and the first maintenance window and the second maintenance window are provided on a left side of the cabinet door in the width direction of the cabinet door.

23. The energy storage system according to claim 17, whereinthe external circulation compartment is configured to accommodate an outdoor heat exchanger and at least one heat exchange fan, and the outdoor heat exchanger is configured to exchange heat with the outside of the energy storage cabinet.

24. The energy storage system according to claim 23, wherein the heat exchange fan is disposed above the outdoor heat exchanger in the height direction of the cabinet door.

25. The energy storage system according to any one of claims 17 to 24, wherein the external circulation compartment further comprises an air guide shutter and a filter screen, and the air guide shutter and the filter screen are disposed on a side that is of the external circulation compartment and that faces the cabinet door.

26. The energy storage system according to any one of claims 1 to 25, wherein the liquid cooling unit comprises a main frame, a first cover plate, a second cover plate, and a partition plate, and the main frame is mounted on the cabinet door; and
the main frame comprises a first side plate, a second side plate, a third side plate, and a fourth side plate that are sequentially connected head to tail, one end of the partition plate is connected to the first side plate and the other end of the partition plate is connected to the third side plate in the width direction of the cabinet door, the first cover plate is located on a side that is of the main frame and that faces the cabinet body, the first cover plate covers the side that is of the main frame and that faces the cabinet body, the second cover plate is located on a side that is of the main frame and that faces the cabinet door, and the second cover plate covers a part between the partition plate and the second side plate.

27. The energy storage system according to claim 26, wherein the first side plate is provided with a first opening and a second opening, the first opening and the second opening are located between the partition plate and the second side plate, the first opening is located on a side that is of the first side plate and that is close to the second side plate, and the second opening is located on a side that is of the first side plate and that is close to the partition plate.

28. The energy storage system according to any one of claims 1 to 27, wherein a side that is of the cabinet door and that is away from the cabinet body is provided with a mounting opening, the mounting opening is configured to mount the liquid cooling unit, and a protective net is disposed on the mounting opening.

29. The energy storage system according to any one of claims 1 to 28, wherein when the cabinet door covers the cabinet body, the liquid cooling unit overlaps a part of the cabinet body in a projection of a plane that is perpendicular to the height direction of the cabinet body.
